# EUROPEAN PATENT APPLICATION

(11) **EP 3 480 658 A1**
(43) Date of publication of application: **08.05.2019**
(21) Application number: 17819770.3
(22) Date of filing: 02.06.2017
(51) Int. Cl.: G03F 7/039, G03F 7/00, G03F 7/004

(54) **POSITIVE PHOTOSENSITIVE RESIN COMPOSITION, POSITIVE LITHOGRAPHIC PRINTING PLATE, AND METHOD FOR MANUFACTURING LITHOGRAPHIC PRINTING PLATES**

(30) Priority: 29.06.2016 JP 2016129345
(71) Applicant: FUJIFILM Corporation, Tokyo 106-8620 (JP)
(72) Inventor: YASUHARA, Yuichi, Haibara-gun Shizuoka 421-0396 (JP); NOZAKI, Atsuyasu, Haibara-gun Shizuoka 421-0396 (JP)
(74) Representative: Hoffmann Eitle
(86) International application number: PCT/JP2017/020696
(87) International publication number: WO 2018/003405

(57) **Abstract**

Provided is a positive type photosensitive resin composition including: a polymer compound which contains, in a main chain thereof, a sulfonamide group and a structure represented by Formula A-1; and an infrared absorbent. In Formula A-1, X represents -NR¹-, -S-, or -O-, R¹ represents a hydrogen atom or an alkyl group, and each symbol "*" independently represents a bonding position with respect to another structure.

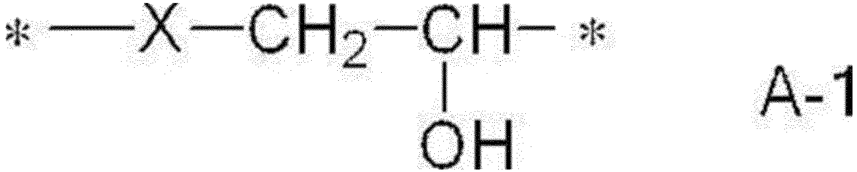

## Description

### BACKGROUND OF THE INVENTION

### 1. Field of the Invention

The present disclosure relates to a positive type photosensitive resin composition, a positive type planographic printing plate precursor, and a method of preparing a planographic printing plate.

### 2. Description of the Related Art

In recent years, lasers have been remarkably developed, and in particular, solid-state lasers and semiconductor lasers having an emission region in a near infrared region to an infrared region, with a high output and a small size, have become easily available. In the field of planographic printing, as an exposure light source at the time of plate-making directly from digital data from a computer or the like, these lasers are very useful.

A positive type planographic printing plate precursor for an infrared laser has an alkali-soluble binder resin and an infrared absorbent and the like which absorb light and generate heat, as components. In the unexposed portion (image area), this infrared absorbent and the like act as a development restrainer which substantially decreases the solubility of a binder resin in a developer due to an interaction between the infrared absorbent and the like and the binder resin, and in the exposed portion (non-image area), the interaction between the infrared absorbent and the like and the binder resin weakens due to generated heat, the infrared absorbent and the like are dissolved in an alkaline developer, and as a result, a planographic printing plate is formed.

Since the image forming capability of a positive type planographic printing plate precursor for an infrared laser as described above depends on the heat generated by a surface of a recording layer being exposed to an infrared laser, in the vicinity of a support, an image is formed by diffusion of heat to the support, that is, the heat quantity to be used for solubilization of the recording layer is reduced, and thus, the sensitivity becomes low. Therefore, there is a problem in that development restraining capability loss effects of the recording layer in the non-image area are not sufficiently obtained, a difference between the image area and the non-image area is reduced, and thus, highlight reproducibility is insufficient.

In order to solve the above-described problem of the highlight reproducibility, using a recording layer formed of a material having characteristics in which a non-image area can be more easily developed, that is, the solubility in an alkali aqueous solution is excellent may be considered, but there is a problem in that such a recording layer becomes chemically weakened even in the image area region and easily damaged by the developer, an ink washing solvent used during printing, or the plate cleaner, which means that the chemical resistance deteriorates. Further, there is demand for a resin material having characteristics in which the chemical resistance and the durability of a coating film in the unexposed portion region are excellent and the developability thereof is excellent after the dissolution suppressing action is removed due to exposure.

For the same purpose as described above, various improved techniques have been proposed, and for example, a technique for a planographic printing plate precursor in which a recording layer which contains a photosensitive composition containing a polyurethane resin having sulfonamide in the main chain which is insoluble in water and soluble in an alkaline aqueous solution, and a photosensitive compound which acts as a positive type (for example, refer to JP1990-156241A (JP-H02-156241A)), a water-insoluble and alkali-soluble resin having an active hydrogen in the main chain, on a support, and an infrared absorbent and whose solubility in an alkaline aqueous solution is increased due to exposure is provided has been disclosed (for example, refer to JP2005-106910A). According to these planographic printing plate precursors, it is possible to provide a positive type planographic printing plate precursor having excellent printing durability and excellent chemical resistance.

### SUMMARY OF THE INVENTION

However, in recent years, diversification of print materials (paper, ink, and the like) has progressed, and even in a case of using the same printing plate, there is a problem in that the number of printable sheets (hereinafter, referred to as "printing durability") is greatly reduced depending on the type of a print material. In a case of the planographic printing plate precursor described in JP1990-156241A (JP-H02-156241A), chemical resistance is excellent, but there is a problem in that particularly the printing durability in printing performed using a low-quality print material (paper or ink) is greatly degraded because the film hardness of a resin used in a lower layer is not sufficient. Further, the developability is not sufficient, and in the planographic printing plate precursor described in JP2005-106910A, the printing durability and the developability in printing performed using a high-quality print material (paper or ink) are excellent. However, there is a problem in that particularly the printing durability in printing performed using a low-quality print material (paper or ink) is greatly degraded because the film hardness of the resin used in a lower layer is not sufficient, and thus, this technique also has room for improvement. Therefore, it is difficult to maintain and improve a plurality of characteristics such as the printing durability depending on the film hardness of the lower layer, the chemical resistance, and the developability.

An object of an embodiment of the present invention is to provide a positive type photosensitive resin composition which enables production of a positive type planographic printing plate precursor with excellent developability and enables production of a planographic printing plate with excellent printing durability and ink impression properties; a positive type planographic printing plate precursor obtained by using the positive type photosensitive resin composition; and a method of preparing a planographic printing plate.

Means for solving the above-described problems includes the following aspects.
<1> A positive type photosensitive resin composition including:
   a polymer compound which contains, in a main chain thereof, a sulfonamide group and a structure represented by Formula A-1; and
   an infrared absorbent.

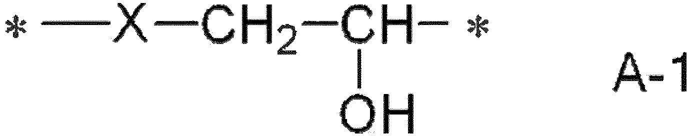

   In Formula A-1, X represents -NR¹-, -S-, or -O-; R¹ represents a hydrogen atom or an alkyl group; and each symbol "*" independently represents a bonding position with respect to another structure.
<2> The positive type photosensitive resin composition according to <1>, in which X represents -NR¹-.
<3> The positive type photosensitive resin composition according to <1>, in which the polymer compound includes a constitutional unit represented by Formula A-2 as a constitutional unit having the structure represented by Formula A-1. 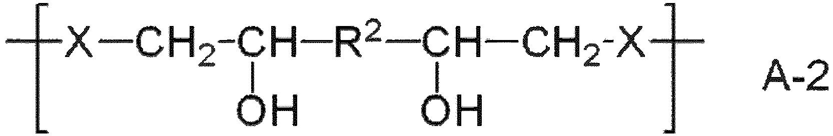
   In Formula A-2, R² represents a divalent linking group; each X independently represents -NR¹-, -S-, or -O-, and each R¹ independently represents a hydrogen atom or an alkyl group.
<4> The positive type photosensitive resin composition according to <3>, in which R² represents a divalent linking group containing a bisphenol structure, a divalent linking group containing an alkyleneoxy group, or a divalent linking group containing a biphenyl structure.
<5> The positive type photosensitive resin composition according to <3> or <4>, in which both of two X's in Formula A-2 represent -NR¹-.
<6> The positive type photosensitive resin composition according to any one of <1> to <5>, in which the polymer compound includes a constitutional unit represented by Formula B-1 as a constitutional unit containing the sulfonamide group. 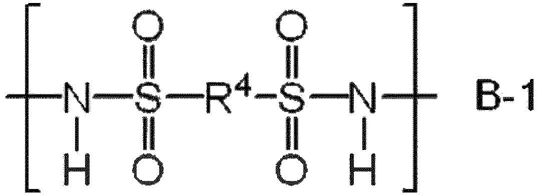
   In Formula B-1, R⁴ represents a divalent linking group.
<7> The positive type photosensitive resin composition according to <6>, in which R⁴ represents a divalent linking group containing a polycyclic structure or a divalent linking group containing a phenylene group.
<8> The positive type photosensitive resin composition according to <6> or <7>, in which the constitutional unit represented by Formula B-1 includes at least one constitutional unit selected from the group consisting of constitutional units each represented by any one of Formulae B1-1 to B1-6. 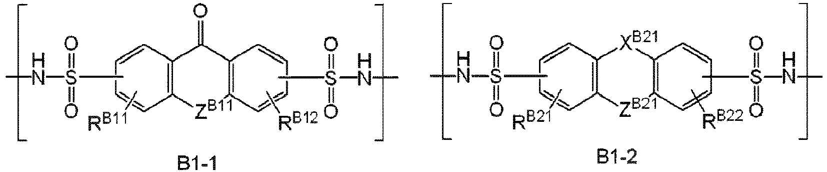 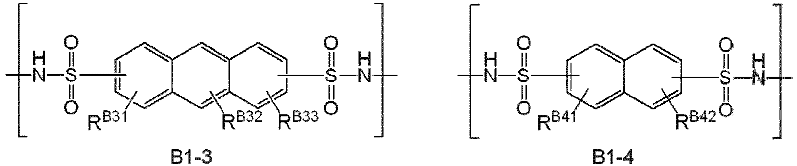 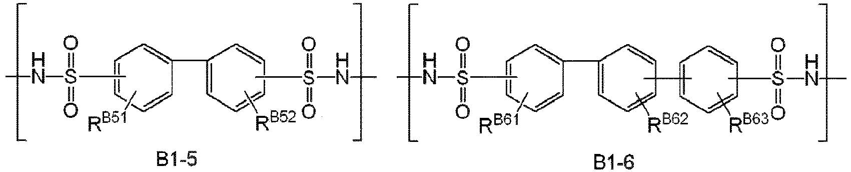
   In Formulae B1-1 to B1-6, each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom; Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group; X^{B21} represents -C(R')₂-, -O-, -NR'-, -S-, or a single bond, and each R independently represents a hydrogen atom or an alkyl group.
<9> The positive type photosensitive resin composition according to any one of <1> to <5>, in which the polymer compound includes a constitutional unit represented by Formula B-2 as a constitutional unit containing the sulfonamide group. 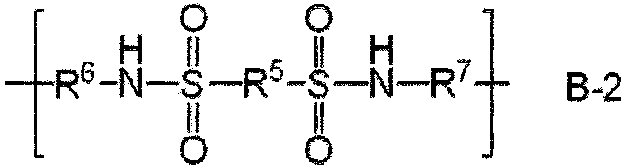
   In Formula B-2, each of R⁵ to R⁷ independently represents a divalent linking group.
<10> The positive type photosensitive resin composition according to <9>, in which R⁵ represents a divalent linking group containing a phenylene group or a divalent linking group containing a polycyclic structure, and each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups linked to one another.
<11> The positive type photosensitive resin composition according to <9>, in which the constitutional unit represented by Formula B-2 includes at least one constitutional unit selected from the group consisting of constitutional units each represented by any one of Formulae B2-1 to B2-6. 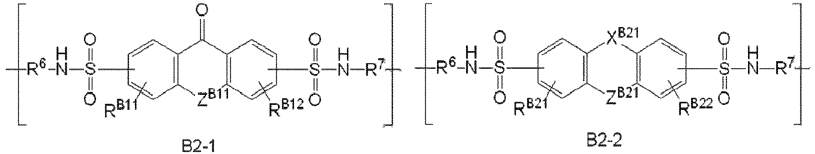 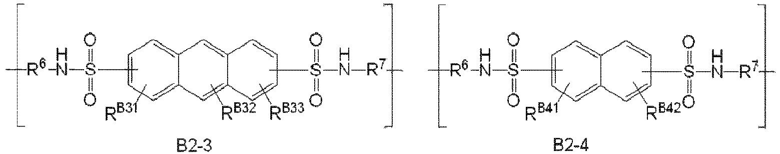 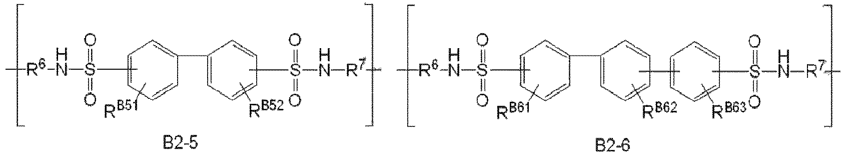
   In Formulae B2-1 to B2-6, each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups linked to one another; each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom; Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group; X^{B21} represents -C(R')₂-, -O-, -NR'-, -S-, or a single bond, and each R independently represents a hydrogen atom or an alkyl group.
<12> A positive type planographic printing plate precursor comprising:
   a support which has a hydrophilic surface; and
   an image recording layer which contains the positive type photosensitive resin composition according to any one of <1> to <11>, on the support.
<13> The positive type planographic printing plate precursor according to <12>, in which the image recording layer has a lower layer and an upper layer from a support side, and at least one of the lower layer and the upper layer comprises the positive type photosensitive resin composition.
<14> The positive type planographic printing plate precursor according to <12> or <13>, further comprising an undercoat layer between the support having the hydrophilic surface and the image recording layer.
<15> A method of preparing a planographic printing plate, comprising:
   an exposure step of subjecting the positive type planographic printing plate precursor according to any one of <12> to <14> to image-wise exposure; and
   a development step of subjecting the exposed positive type planographic printing plate precursor to development using an alkali aqueous solution having a pH of 8.5 to 13.5.

According to one embodiment of the present invention, it is possible to provide a positive type photosensitive resin composition which enables production of a positive type planographic printing plate precursor with excellent developability and enables production of a planographic printing plate with excellent printing durability and ink impression properties; a positive type planographic printing plate precursor obtained by using the positive type photosensitive resin composition; and a method of preparing a planographic printing plate.

### DESCRIPTION OF THE PREFERRED EMBODIMENTS

Hereinafter, the contents of the present disclosure will be described in detail.

The description of constitutive elements below is made based on representative embodiments of the present invention in some cases, but the present invention is not limited to such embodiments.

Further, in the present disclosure, the numerical ranges shown using "to" indicate ranges including the numerical values described before and after "to" as the lower limit values and the upper limit values.

In the present disclosure, in a case where substitution or unsubstitution is not noted in regard to the notation of a group (atomic group), the group includes not only a group that does not have a substituent but also a group having a substituent. For example, the concept of an "alkyl group" includes not only an alkyl group that does not have a substituent (unsubstituted alkyl group) but also an alkyl group having a substituent (substituted alkyl group).

In addition, the chemical structural formulae in the present specification are described using simplified structural formulae in which hydrogen atoms have been omitted, in some cases.

Moreover, in the present disclosure, "(meth)acrylate" represents acrylate and methacrylate, "(meth)acrylic" represents acrylic and methacrylic, and "(meth)acryloyl" represents acryloyl and methacryloyl.

In addition, in the present disclosure, "% by mass" has the same meaning as "% by weight" and "part(s) by mass" has the same meaning as "part(s) by weight".

Further, in the present disclosure, a combination of preferred aspects is a more preferred aspect.

Further, the term "step" in the present disclosure indicates not only an independent step but also a step which cannot be clearly distinguished from other steps as long as the intended purpose of the step is achieved.

Moreover, in the present disclosure, a combination of two or more preferred aspects is a more preferred aspect.

In the present disclosure, the weight-average molecular weight and the number average molecular weight of polymer components are respectively a weight-average molecular weight in terms of polystyrene obtained by performing measurement using gel permeation chromatography (GPC) in a case where tetrahydrofuran (THF) is used as a solvent, unless otherwise specified.

### (Positive type photosensitive resin composition)

A positive type photosensitive resin composition according to the present disclosure includes: a polymer compound which contains, in a main chain thereo, a sulfonamide group and a structure represented by Formula A-1; and an infrared absorbent.

In the present disclosure, a "main chain" indicates relatively the longest bonding chain in a molecule of a polymer compound constituting a resin and a "side chain" indicates a carbon chain branched from the main chain.

As a result of extensive examination conducted by the present inventors, it was found that a positive type planographic printing plate precursor to be obtained using a positive type photosensitive resin composition containing a polymer compound which contains a sulfonamide group and has a structure represented by Formula A-1 in the main chain; and an infrared absorbent has excellent developability and a planographic printing plate to be obtained using the positive type photosensitive resin composition has excellent printing durability and ink impression properties.

Although the detailed mechanism for obtaining the excellent effects described above is not clear, it is estimated as follows.

As the result of examination conducted by the present inventors, it was found that the film hardness of a resin is important for the printing durability in printing and the film hardness is significantly influenced by an interaction between polymer compounds forming an image recording layer. In particular, the effect is significant in low-quality print materials, and sufficient film hardness is less likely to be imparted in typical acrylic resins or polyurethane resins. It is thought that this is because inorganic salt particles (calcium carbonate, kaolin, or the like) included in a print material (paper, ink, or the like) are eluted during printing, this polishes the image area of the printing plate, and as a result, abrasion is promoted.

In the polymer compound used for forming an image in the embodiment of the present invention, it is considered that the aggregating properties of the polymer compound are improved by allowing the main chain thereof to have a sulfonamide group. The strength of the image area of the planographic printing plate to be obtained is improved and the printing durability is excellent in a case where such a polymer compound having excellent aggregating properties is used.

Further, the present inventors found that the planographic printing plate prepared using the positive type photosensitive resin composition according to the present disclosure has excellent chemical resistance.

The detailed mechanism is not clear, but it is assumed that such a polymer compound having excellent aggregating properties exhibits excellent effects in terms of chemical resistance because the polymer compound has higher polarity than that of printing chemicals.

Further, it is assumed that the developer permeability in an exposed portion (non-image area) of the planographic printing plate precursor is improved in a case where the polymer compound has a structure represented by Formula A-1 which is a hydrophilic structure. Further, it is assumed that, since sulfonamide groups and hydroxyl groups contained in the structure represented by Formula A-1 have a strong hydrogen bond in a case where the polymer compound has both of a sulfonamide group and a structure represented by Formula A-1, dissolution in a developer is suppressed in an unexposed portion (image area), and thus the time required for dissolution of an image area becomes longer.

It is assumed that a positive type planographic printing plate precursor having excellent developability is obtained due to the effects of the above-described two points.

Further, it is assumed that the ink impression properties are improved due to an interaction of the hydroxyl group contained in Formula A-1 and the sulfonamide group with the components in the ink.

It is assumed that the planographic printing plate of the present disclosure has excellent ink impression properties because of the high affinity of the monomer components which are present in the ink and the hydroxyl group and the sulfonamide group, particularly in a UV ink (ultraviolet curable ink).

Hereinafter, each component contained in the positive type photosensitive resin composition of the present disclosure will be described.

### <Polymer compound containing sulfonamide group and having structure represented by Formula A-1 in main chain>

The positive type photosensitive resin composition of the present disclosure contains a polymer compound (hereinafter, also referred to as a "specific polymer compound") containing, in the main chain thereof, a sulfonamide group and a structure represented by Formula A-1.

### [Structure represented by Formula A-1]

The specific polymer compound used in the present disclosure has a structure represented by Formula A-1 in the main chain.

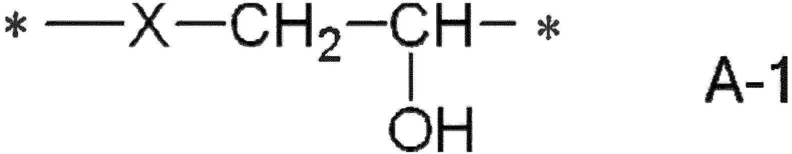

In Formula A-1, X represents -NR¹-, -S-, or -O-, R¹ represents a hydrogen atom or an alkyl group, and each symbol "*" independently represents a bonding position with respect to another structure.

In Formula A-1, X represents -NR¹-, -S-, or -O-, preferably -NR¹- or -S- from the viewpoint of the printing durability, preferably -NR¹- or -O- from the viewpoint of the developability, and preferably -NR¹- from the viewpoints of both of the developability and the printing durability.

R¹ represents a hydrogen atom or an alkyl group and preferably a hydrogen atom or an alkyl group having 1 to 8 carbon atoms, and examples of the alkyl group having 1 to 8 carbon atoms include an aliphatic hydrocarbon group such as a methyl group, an ethyl group, a propyl group, a butyl group, a pentyl group, or a hexyl group; an aromatic hydrocarbon group such as a phenyl group; and an alicyclic hydrocarbon group such as a cyclopropyl group, a cyclopentyl group, a cyclohexyl group, or a 1-cyclohexenyl group. In addition, a hydrogen atom or an alkyl group having 1 to 4 carbon atoms is more preferable, and a hydrogen atom is still more preferable.

### [Constitutional unit represented by Formula A-2]

It is preferable that the specific polymer compound has a constitutional unit represented by Formula A-2 as a constitutional unit having the structure represented by Formula A-1. The constitutional unit represented by Formula A-2 is a constitutional unit having the structure represented by Formula A-1.

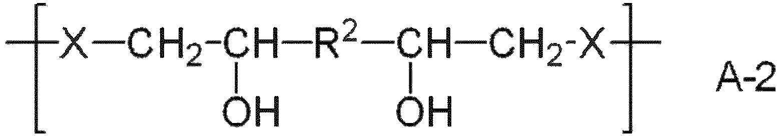

In Formula A-2, R² represents a divalent linking group, each X independently represents -NR¹-, -S-, or -O-, and each R¹ independently represents a hydrogen atom or an alkyl group.

In Formula A-2, R² represents a divalent linking group, preferably a divalent linking group having a bisphenol structure, a divalent linking group containing an alkyleneoxy group, or a divalent linking group having a biphenyl structure from the viewpoint of improving the chemical resistance of the planographic printing plate to be obtained, and more preferably a divalent linking group having a bisphenol structure from the viewpoint of improving the printing durability of the planographic printing plate to be obtained.

In Formula A-2, X represents -NR¹-, -S-, or -O-, preferably -NR¹- or -S- from the viewpoint of the printing durability, preferably -NR¹- or -O- from the viewpoint of the developability, and preferably -NR¹- from the viewpoints of both of the developability and the printing durability.

In Formula A-2, two X's may be different from each other, and it is preferable that two X's are the same as each other.

In other words, in Formula A-2, both of two X's represent preferably -NR¹- or -S-from the viewpoint of the printing durability, both of two X's represent preferably -NR¹- or -O- from the viewpoint of the developability, and both of two X's represent preferably -NR¹- from the viewpoint of achieving both of the developability and the printing durability.

R¹ represents a hydrogen atom or an alkyl group, preferably a hydrogen atom or an alkyl group having 1 to 8 carbon atoms, more preferably a hydrogen atom or an alkyl group having 1 to 4 carbon atoms, and still more preferably a hydrogen atom.

### - Divalent linking group having bisphenol structure -

As the divalent linking group having a bisphenol structure, a divalent linking group having at least one structure selected from the group consisting of a bisphenol A structure and a bisphenol F structure is preferable, and a divalent linking group having both of a bisphenol A structure and a bisphenol F structure is more preferable.

As the divalent linking group having a bisphenol structure, a linking group represented by Formula A2-1 is preferable.

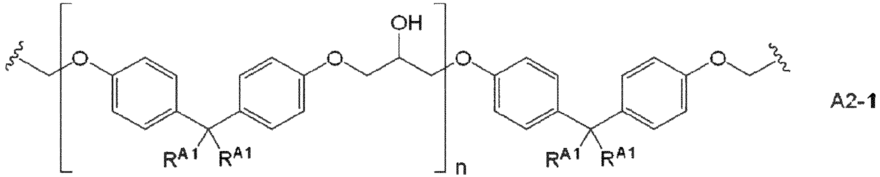

In Formula A2-1, each R^{A1} independently represents a hydrogen atom or an alkyl group, n represents an integer of 0 to 100, and each wavy line part independently represents a bonding position with respect to a carbon atom having a hydroxyl group contained in the structure represented by Formula A-1.

In Formula A2-1, each R^{A1} independently represents a hydrogen atom or an alkyl group and preferably CH₃.

In Formula A2-1, n represents an integer of 0 to 100, preferably an integer of 3 to 50, and more preferably an integer of 5 to 30.

A benzene ring contained in Formula A2-1 may be substituted or unsubstituted, but it is preferable that the benzene ring is unsubstituted. Examples of the substituent which may be included in the benzene ring include a halogen atom. Among the examples, a bromine atom is preferable.

It is preferable that the linking group represented by Formula A2-1 is a linking group represented by Formula A2-1-1.

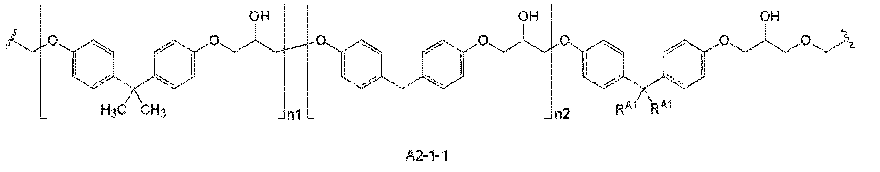

In Formula A2-1-1, n1 represents an integer of 0 to 50, n2 represents an integer of 0 to 50, each R^{A1} independently represents a hydrogen atom or an alkyl group, and each wavy line part independently represents a bonding position with respect to a carbon atom having a hydroxyl group contained in the structure represented by Formula A-1.

Further, in the linking group represented by Formula A2-1-1, n1 constitutional units and n2 constitutional units in the formula may be alternately arranged, arranged in the form of a block, or randomly arranged.

In Formula 2-1-1, n1 represents an integer of 0 to 50, preferably an integer of 1 to 25, and more preferably an integer of 2 to 15.

In Formula 2-1-1, n2 represents an integer of 0 to 50, preferably an integer of 1 to 25, and more preferably an integer of 2 to 15.

In Formula 2-1-1, the total value of n1 and n2 is preferably an integer of 0 to 100, more preferably an integer of 3 to 50, and still more preferably an integer of 5 to 20.

In Formula A2-1-1, each R^{A1} independently represents a hydrogen atom or an alkyl group, preferably a hydrogen atom or a methyl group, and more preferably a methyl group.

Further, two R^{A1}'s may be the same as or different from each other, but it is preferable that two R^{A1}'s are the same as each other.

A benzene ring contained in Formula A2-1-1 may be substituted or unsubstituted, but it is preferable that the benzene ring is unsubstituted. Examples of the substituent which may be included in the benzene ring include a halogen atom. Among the examples, a bromine atom is preferable.

### - Divalent linking group containing alkyleneoxy group -

As the alkyleneoxy group in the divalent linking group containing an alkyleneoxy group, an alkyleneoxy group having 2 to 10 carbon atoms is preferable, an alkyleneoxy group having 2 to 8 carbon atoms is more preferable, an alkyleneoxy group having 2 to 4 carbon atoms is still more preferable, and an ethyleneoxy group or a propyleneoxy group is particularly preferable.

The alkyleneoxy group may have a substituent. Examples of the substituent include a hydroxyl group and a halogen atom, and preferred examples thereof include a hydroxyl group and a chlorine atom.

As the alkyleneoxy group, a polyalkyleneoxy group is preferable.

As the polyalkyleneoxy group, a polyalkyleneoxy group having 2 to 30 repeating units is preferable, a polyalkyleneoxy group having 2 to 20 repeating units is more preferable, and a polyalkyleneoxy group having 2 to 10 repeating units is still more preferable.

The preferable number of carbon atoms in the repeating unit of the polyalkyleneoxy group is the same as the preferable number of carbon atoms of the alkyleneoxy group.

As the divalent linking group containing an alkyleneoxy group, a divalent linking group represented by Formula A2-2 is more preferable.

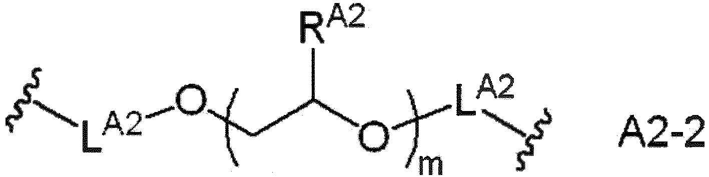

In Formula A2-2, each R^{A2} independently represents a hydrogen atom or an alkyl group, m represents an integer of 1 to 20, each L^{A2} independently represents an alkylene group or an arylene group, and each wavy line part independently represents a bonding position with respect to a carbon atom having a hydroxyl group contained in the structure represented by Formula A-1.

In Formula A2-2, each R^{A2} independently represents a hydrogen atom or an alkyl group, preferably a hydrogen atom or an alkyl group having 1 to 4 carbon atoms, more preferably a hydrogen atom or a methyl group, and still more preferably a hydrogen atom.

In Formula A2-2, each L^{A2} independently represents an alkylene group or an arylene group, preferably an alkylene group having 1 to 10 carbon atoms (such as a methylene group, an ethylene group, or a propylene group) or an arylene group having 6 to 20 carbon atoms (such as a phenylene group, a xylylene group, or a naphthylene group), more preferably an alkylene group having 1 to 10 carbon atoms, and still more preferably an alkylene group having 1 to 4 carbon atoms.

In Formula A2-2, m represents an integer of 1 to 20, preferably an integer of 2 to 20, and more preferably an integer of 2 to 10.

### - Divalent linking group having biphenyl structure -

It is preferable that the divalent linking group having a biphenyl structure is a divalent linking group represented by Formula A2-3.

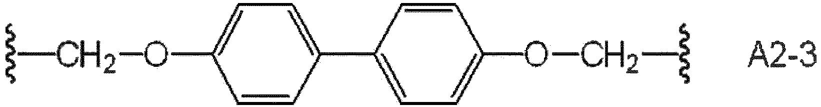

In Formula A2-3, each wavy line part independently represents a bonding position with respect to a carbon atom having a hydroxyl group contained in the structure represented by Formula A-1.

A benzene ring contained in Formula A2-3 may be substituted or unsubstituted, but it is preferable that the benzene ring is unsubstituted. Examples of the substituent which may be included in the benzene ring include a halogen atom. Among the examples, a bromine atom is preferable.

The content of the constitutional unit represented by Formula A-2 in the specific polymer compound used in the present disclosure is preferably in a range of 10% by mass to 90% by mass, more preferably in a range of 20% by mass to 80% by mass, and still more preferably in a range of 30% by mass to 70% by mass with respect to the total mass of the specific polymer compound.

In a case where the content of the constitutional unit is in the above-described range, a positive type photosensitive resin composition that enables production of a planographic printing plate having excellent printing durability is obtained.

It is preferable that the constitutional unit represented by Formula A-2 is a constitutional unit derived from a compound containing two epoxy groups described below.

### [Constitutional unit represented by Formula B-1]

It is preferable that the specific polymer compound used in the present disclosure has a constitutional unit represented by Formula B-1 as the constitutional unit containing a sulfonamide group. Both of two sulfonamide groups in Formula B-1 are sulfonamide groups contained in the specific polymer compound in the main chain thereof.

In a case where the specific polymer compound has a constitutional unit represented by Formula B-1, since the acid value of the specific polymer compound is increased due to the structure thereof, a positive type photosensitive resin composition that enables production of a positive type planographic printing plate precursor having excellent developability is obtained.

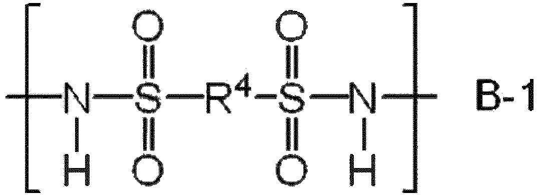

In Formula B-1, R⁴ represents a divalent linking group.

R⁴ represents preferably a divalent linking group having a polycyclic structure or a divalent linking group containing a phenylene group from the viewpoints of the printing durability and the chemical resistance and more preferably a divalent linking group having a polycyclic structure particularly from the viewpoint of the printing durability.

### - Divalent linking group having polycyclic structure -

As the divalent linking group having a polycyclic structure, a divalent linking group formed of a polycyclic structure is preferable.

As the polycyclic structure, a naphthalene derivative structure, an anthracene derivative structure, a biphenyl structure, or a terphenyl structure is preferable, and a xanthone structure, a fluorenone structure, a xanthene structure, a dihydroanthracene structure, an anthracene structure, a biphenyl structure, or a terphenyl structure is more preferable. From the viewpoints of the chemical resistance, the printing durability, and the developability, a xanthone structure, a fluorenone structure, a biphenyl structure, or a naphthalene structure is preferable, and a xanthone structure or a fluorenone structure is more preferable.

### - Constitutional unit represented by any of Formulae B1-1 to B1-6-

The constitutional unit represented by Formula B-1 contains preferably at least one constitutional unit selected from the group consisting of constitutional units represented by any of Formulae B1-1 to B1-6, more preferably at least one constitutional unit selected from the group consisting of constitutional units represented by Formula B1-1, B1-2, B1-5, or B1-6, and still more preferably at least one constitutional unit selected from the group consisting of constitutional units represented by Formula B1-1 or B1-2.

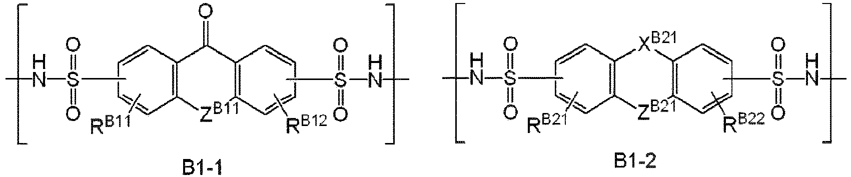

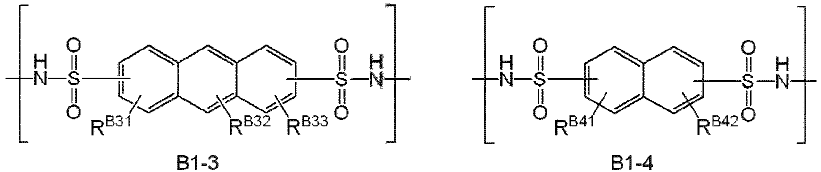

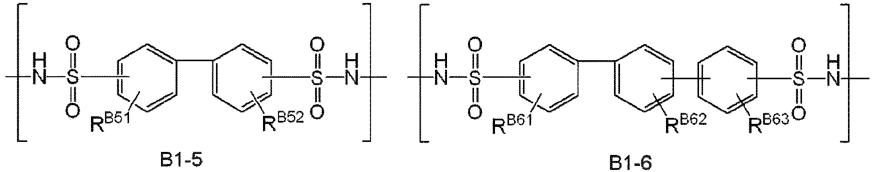

In Formulae B1-1 to B1-6, each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom, Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group, X^{B21} represents -C(R')₂-, -O-, -NR'-, -S-, or a single bond, and each R independently represents a hydrogen atom or an alkyl group.

In Formulae B1-1 to B-6, each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group (preferably an alkyl group having 1 to 10 carbon atoms, for example, an aliphatic hydrocarbon group such as a methyl group, an ethyl group, a propyl group, a butyl group, a pentyl group, or a hexyl group; an aromatic hydrocarbon group such as a phenyl group; and an alicyclic hydrocarbon group such as a cyclopropyl group, a cyclopentyl group, a cyclohexyl group, or a 1-cyclohexenyl group), or a halogen atom (preferably at least one selected from the group consisting of a fluorine atom, a chlorine atom, a bromine atom, and an iodine atom), preferably a hydrogen atom, an alkyl group, or a halogen atom, and more preferably a hydrogen atom. Further, from the viewpoint of improving the developability, it is preferable that each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents an acidic group such as a sulfonamide group, a hydroxyl group, or a carboxyl group.

Z^{B11} represents -C(R)₂-, -C(=O)-, -O-, -NR-, -S-, or a single bond, preferably -C(R)₂-, -O-, or a single bond, and more preferably -O- or a single bond.

Each R independently represents a hydrogen atom or an alkyl group (preferably an alkyl group having 1 to 10 carbon atoms, for example, an aliphatic hydrocarbon group such as a methyl group, an ethyl group, a propyl group, a butyl group, a pentyl group, or a hexyl group; an aromatic hydrocarbon group such as a phenyl group; and an alicyclic hydrocarbon group such as a cyclopropyl group, a cyclopentyl group, a cyclohexyl group, or a 1-cyclohexenyl group) and preferably a hydrogen atom.

Z^{B21} represents -C(R)₂-, -O-, -NR-, -S-, or a single bond, preferably -C(R)₂- or -O-, and more preferably -O-.

X^{B21} represents -C(R')₂-, -O-, -NR'-, -S-, or a single bond and preferably -C(R')₂-.

Each R independently represents a hydrogen atom or an alkyl group (preferably an alkyl group having 1 to 10 carbon atoms, for example, an aliphatic hydrocarbon group such as a methyl group, an ethyl group, a propyl group, a butyl group, a pentyl group, or a hexyl group; an aromatic hydrocarbon group such as a phenyl group; and an alicyclic hydrocarbon group such as a cyclopropyl group, a cyclopentyl group, a cyclohexyl group, or a 1-cyclohexenyl group) and preferably a hydrogen atom.

### - Divalent linking group containing phenylene group -

As the divalent linking group containing a phenylene group, a phenylene group or a group represented by Formula B1-7 is preferable.

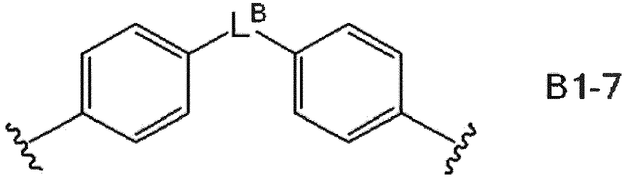

In Formula B1-7, LB represents an ether bond (-O-) or a sulfonyl group (-S(=O)₂-), and the wavy line part represents a bonding site with respect to a sulfur atom of a sulfonamide group contained in the structure represented by Formula B-1.

In a case where R⁴ represents a phenylene group, it is preferable that two sulfonamide groups in Formula B-1 are bonded to the phenylene group so as to be the meta-position.

Further, the phenylene group may be substituted. Examples of the substituent include an alkyl group, a hydroxyl group, and a halogen atom. Among these, an alkyl group is preferable. As the alkyl group, an alkyl group having 1 to 8 carbon atoms is preferable, an alkyl group having 1 to 4 carbon atoms is more preferable, and a methyl group is still more preferable.

### [Constitutional unit represented by Formula B-2]

It is preferable that the specific polymer compound used in the present disclosure has a constitutional unit represented by formula B-2 as the constitutional unit containing a sulfonamide group. The sulfonamide group in Formula B-2 is a sulfonamide group contained in the specific polymer compound in the main chain thereof.

In a case where the specific polymer compound has a constitutional unit represented by Formula B-2, since the acid value of the specific polymer compound is increased due to the structure thereof, a positive type photosensitive resin composition that enables production of a positive type planographic printing plate precursor having excellent developability is obtained.

Further, it is preferable that at least one of R⁶ or R⁷ present at the linking position with respect to another structure in Formula B-2 is bonded to X in Formula A-2 and more preferable that both of R⁶ and R⁷ are bonded to X in Formula A-2.

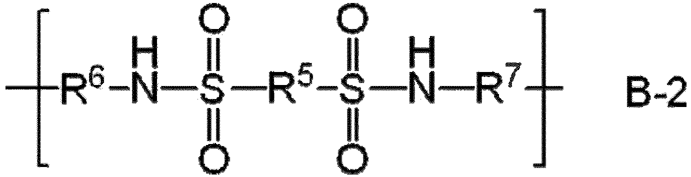

In Formula B-2, each of R⁵ to R⁷ independently represents a divalent linking group.

In Formula B-2, R⁵ has the same definition as that for R⁴ in Formula B-1 and the preferable aspects thereof are the same as described above.

In Formula B-2, each of R⁶ and R⁷ independently represents a divalent linking group, preferably an alkylene group, an arylene group, or a divalent saturated alicyclic hydrocarbon group, a divalent unsaturated alicyclic hydrocarbon group, or a divalent group formed by a plurality of these groups being linked to one another, and more preferably an alkylene group or an arylene group.

As the alkylene group, an alkylene group having 1 to 20 carbon atoms is preferable, an alkylene group having 2 to 15 carbon atoms is more preferable, and an alkylene group having 2 to 8 carbon atoms is still more preferable. Further, the alkylene group may contain oxygen atoms in the carbon chain. Examples of the substituent which may be included in the alkylene group include an alkyl group, an aryl group, and a halogen atom.

As the arylene group, an arylene group having 6 to 20 carbon atoms is preferable, a phenylene group or a naphthylene group is more preferable, and a phenylene group is still more preferable. The arylene group may contain heteroatoms in the ring structure, and examples of the heteroatoms include an oxygen atom, a nitrogen atom, and a sulfur atom.

As the divalent saturated alicyclic hydrocarbon group, a divalent saturated alicyclic hydrocarbon group having 4 to 10 carbon atoms is preferable, a divalent saturated alicyclic hydrocarbon group having 4 to 8 carbon atoms is more preferable, and a divalent saturated alicyclic hydrocarbon group having 6 to 8 carbon atoms is still more preferable. In addition, examples of the substituent which may be contained in the divalent saturated alicyclic hydrocarbon group include an alkyl group, an aryl group, and a halogen atom.

Examples of the divalent unsaturated alicyclic hydrocarbon group include a cyclopentenyl group, a cyclopentadienyl group, a cyclohexenyl group, a cyclohexadienyl group, and a cycloheptenyl group.

As the divalent group formed by a plurality of these groups being linked to one another, a group formed by a plurality of alkylene groups and arylene groups or a plurality of alkylene groups and divalent saturated alicyclic hydrocarbon groups, being bonded to one another, is preferable or a group formed by bonding an alkylene group, an arylene group, and an alkylene group in this order or bonding an alkylene group, a divalent saturated alicyclic hydrocarbon group, and an alkylene group in this order is preferable.

### - Constitutional unit represented by any of Formulae B2-1 to B2-6 -

The constitutional unit represented by Formula B-2 contains preferably at least one constitutional unit selected from the group consisting of constitutional units represented by any of Formulae B2-1 to B2-6, more preferably at least one constitutional unit selected from the group consisting of constitutional units represented by Formula B2-1, B2-2, B2-5, or B2-6, and still more preferably at least one constitutional unit selected from the group consisting of constitutional units represented by Formula B2-1 or B2-2.

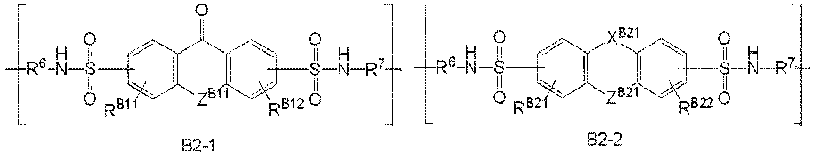

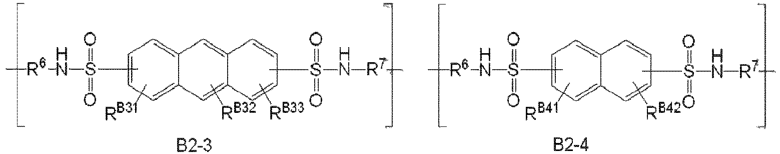

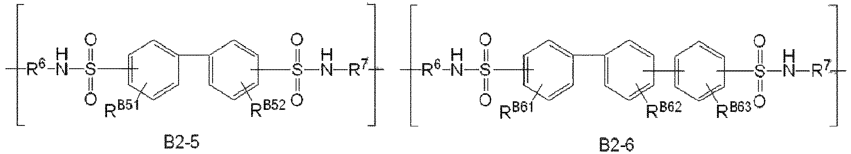

In Formulae B2-1 to B2-6, each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups linked to one another, each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom, Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group, X^{B21} represents -C(R')₂-, -O-, -NR'-, -S-, or a single bond, and each R independently represents a hydrogen atom or an alkyl group.

In Formulae B2-1 to B2-6, each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups being linked to one another.

As the alkylene group, an alkylene group having 1 to 20 carbon atoms is preferable, an alkylene group having 2 to 15 carbon atoms is more preferable, and an alkylene group having 2 to 8 carbon atoms is still more preferable. Further, the alkylene group may contain oxygen atoms in a carbon chain. Examples of the substituent which may be included in the alkylene group include an alkyl group, an aryl group, and a halogen atom.

As the arylene group, an arylene group having 6 to 20 carbon atoms is preferable, a phenylene group or a naphthylene group is more preferable, and a phenylene group is still more preferable. The arylene group may contain heteroatoms in a ring structure, and examples of the heteroatom include an oxygen atom, a nitrogen atom, and a sulfur atom.

As the divalent saturated alicyclic hydrocarbon group, a divalent saturated alicyclic hydrocarbon group having 4 to 10 carbon atoms is preferable, a divalent saturated alicyclic hydrocarbon group having 4 to 8 carbon atoms is more preferable, and a divalent saturated alicyclic hydrocarbon group having 6 to 8 carbon atoms is still more preferable. Further, examples of the substituent which may be contained in the divalent saturated alicyclic hydrocarbon group include an alkyl group, an aryl group, and a halogen atom.

As the divalent unsaturated alicyclic hydrocarbon group, a cyclopentenyl group, a cyclopentadienyl group, a cyclohexenyl group, a cyclohexadienyl group, and a cycloheptenyl group are exemplified.

As the divalent group formed by a plurality of these groups being linked to one another, a group in which a plurality of alkylene groups and arylene groups or a plurality of alkylene groups and divalent saturated alicyclic hydrocarbon groups are bonded is preferable and a group in which an alkylene group, an arylene group, and an alkylene group or an alkylene group, a divalent saturated alicyclic hydrocarbon group, and an alkylene group are bonded in this order is preferable.

In Formulae B2-1 to B2-6, R^{B11}, R^{B12}, R^{B21}, R^{B22}, R^{B31} to R^{B33}, R^{B41}, R^{B42}, R^{B51}, R^{B52}, R^{B61} to R^{B63}, Z^{B11}, Z^{B21}, and X^{B21} each have the same definition as that for R^{B11}, R^{B12}, R^{B21}, R^{B22} , R^{B31} to R^{B33}, R^{B41}, R^{B42}, R^{B51}, R^{B52}, R^{B61} to R^{B63}, Z^{B11}, Z^{B21}, and X^{B21} in Formulae B1-1 to B 1-6 and the preferable aspects thereof are the same as described above.

From the viewpoint of the developability of the planographic printing plate to be obtained, the content of the constitutional unit represented by Formula B-2 in the specific polymer compound used in the present disclosure is preferably in a range of 10% by mass to 90% by mass, more preferably in a range of 20% by mass to 80% by mass, and still more preferably in a range of 30% by mass to 70% by mass with respect to the total mass of the specific polymer compound.

It is preferable that the constitutional unit represented by Formula B-2 is a constitutional unit derived from a sulfonamide group-containing compound described below.

### [Alkyleneoxy group]

It is preferable that the specific polymer compound used in the present disclosure further includes an alkyleneoxy group in the main chain.

According to the above-described aspect, it is possible to obtain a positive type photosensitive resin composition which enables production of a positive type planographic printing plate precursor having excellent image formability and enables production of a planographic printing plate having excellent printing durability.

As the alkyleneoxy group, an alkyleneoxy group having 2 to 10 carbon atoms is preferable, an alkyleneoxy group having 2 to 8 carbon atoms is more preferable, an alkyleneoxy group having 2 to 4 carbon atoms is still more preferable, and an ethyleneoxy group or a propyleneoxy group is particularly preferable.

Further, the alkyleneoxy group may be a polyalkyleneoxy group.

As the polyalkyleneoxy group, a polyalkyleneoxy group having 2 to 50 repeating units is preferable, a polyalkyleneoxy group having 2 to 40 repeating units is more preferable, and a polyalkyleneoxy group having 2 to 30 repeating units is still more preferable.

The preferable number of carbon atoms in the repeating units of the polyalkyleneoxy group is the same as the preferable number of carbon atoms of the alkyleneoxy group.

It is preferable that the alkyleneoxy group is contained in a constitutional unit derived from a compound that does not contain a sulfonamide group described below.

### [Other acid groups]

From the viewpoint of the developability, the specific polymer compound used in the present disclosure may further contain acid groups other than the sulfonamide group in the main chain.

Examples of other acid groups include a carboxyl group, a phenolic hydroxyl group, and a sulfonamide group contained in a side chain. Among these, a sulfonamide group contained in a side chain is preferable.

It is preferable that other acid groups are contained in a constitutional unit derived from a compound that does not contain a sulfonamide group described below.

### [Examples of specific polymer compound]

It is preferable that the specific polymer compound used in the present disclosure is a polymer compound represented by Formula D-1.

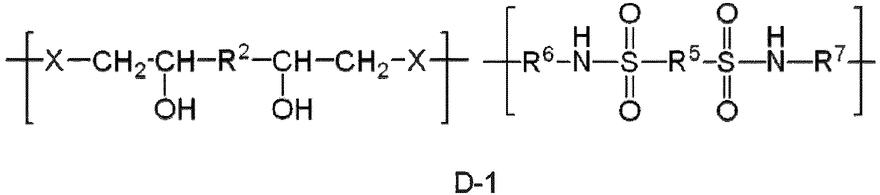

In Formula D-1, R² has the same definition as that for R² in Formula A-2 and the preferable aspects thereof are the same as described above.

In Formula D-1, R⁵, R⁶, and R⁷ in Formula B-2 each have the same definition as that for R⁵, R⁶, and R⁷ and the preferable aspects thereof are the same as described above.

Further, it is preferable that the specific polymer compound used in the present disclosure is a polymer compound represented by Formula D-2.

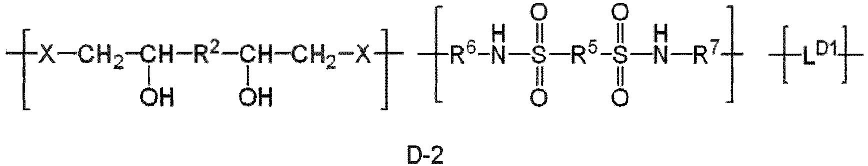

In Formula D-2, R² has the same definition as that for R² in Formula A-2 and the preferable aspects thereof are the same as described above.

In Formula D-2, R⁵, R⁶, and R⁷ each have the same definition as that for R⁵, R⁶, and R⁷ in Formula B-2 and the preferable aspects thereof are the same as described above.

In Formula D-2, L^{D1} represents an alkylene group, an alkyleneoxy group, a polyalkyleneoxy group, an arylene group, or a group formed by a plurality of these groups being bonded to one another. Among these, an alkylene group, a polyalkyleneoxy group, or a group formed by a plurality of these groups being bonded to one another is preferable.

The number of carbon atoms of the alkylene group is preferably in a range of 1 to 20 and more preferably in a range of 1 to 8. Further, the alkylene group may be linear, branched, or cyclic.

The alkyl group may include a substituent, and examples of the substituent include an aryl group, an aralkyl group, and a halogen atom. The substituent may be bonded to an alkyl group through an amide bond or an ester bond. Further, the substituent may further have a substituent. From the viewpoint of the developability, it is preferable that the substituent further includes an acid group as a substituent. Examples of the acid group include a carboxyl group, a phenolic hydroxyl group, and a sulfonamide group. Among these, a sulfonamide group is preferable.

The number of carbon atoms of the alkyleneoxy group is preferably in a range of 2 to 10 and more preferably in a range of 2 to 4. In addition, an ethyleneoxy group or a propyleneoxy group is still more preferable.

As the polyalkyleneoxy group, a polyalkyleneoxy group having 2 to 50 repeating units is preferable, a polyalkyleneoxy group having 2 to 40 repeating units is more preferable, and a polyalkyleneoxy group having 2 to 30 repeating units is still more preferable.

The preferable number of carbon atoms in the repeating units of the polyalkyleneoxy group is the same as the preferable number of carbon atoms of the alkyleneoxy group.

As the arylene group, a phenylene group or a naphthylene group is preferable and a phenylene group is more preferable.

As the group formed by a plurality of these groups being bonded to one another, an alkylene-arylene-alkylene group and an alkylene-polyalkyleneoxy-alkylene group are exemplified.

The terminal of the specific polymer compound used in the present disclosure is not particularly limited and is determined according to the reaction stopping conditions and the group contained in the compound used as a monomer, and examples thereof include an amino group, a hydroxyl group, and a thiol group. Further, the terminal of the specific polymer compound may be blocked by a known terminal blocking agent.

### [Method of producing specific polymer compound]

The specific polymer compound used in the present disclosure can be produced by a sequential polymerization reaction of a group reacting with an epoxy group and a compound containing a sulfonamide group (hereinafter, also simply referred to as a "compound containing a sulfonamide group"), and as necessary, a compound which does not contain a sulfonamide group and contains a group reacting with an epoxy group (hereinafter, also simply referred to as a "compound that does not contain a sulfonamide group"), and a compound containing two epoxy groups. In the present disclosure, the compound containing a sulfonamide group indicates a compound containing a sulfonamide group in the main chain of the specific polymer compound to be obtained after the sequential polymerization, and the compound containing a sulfonamide group in a side chain of the specific polymer compound corresponds to the compound that does not contain a sulfonamide group. For example, the compound represented by Formula DO-11 described below contains a sulfonamide group, and the sulfonamide group is contained in a side chain of the polymer compound to be obtained by the sequential polymerization of the compound represented by Formula DO-11 and the compound containing two epoxy groups. Therefore, the compound represented by Formula DO-11 corresponds to the compound that does not contain a sulfonamide group.

The compound containing a sulfonamide group, the compound that does not contain a sulfonamide group, and the compound containing two epoxy groups each may be used alone or in combination of two or more kinds thereof.

Examples of the group reacting with an epoxy group include an amino group, a thiol group, and a hydroxyl group.

Examples of the compound containing a sulfonamide group include a diamine compound containing a sulfonamide group, a dithiol compound containing a sulfonamide group, and a diol compound containing a sulfonamide group.

Examples of the compound that does not contain a sulfonamide group include a diamine compound that does not contain a sulfonamide group, a dithiol compound that does not contain a sulfonamide group, and a diol compound that does not contain a sulfonamide group.

Hereinafter, the diamine compound containing a sulfonamide group, the dithiol compound containing a sulfonamide group, the diol compound containing a sulfonamide group, the diamine compound that does not contain a sulfonamide group, the dithiol compound that does not contain a sulfonamide group, the diol compound that does not contain a sulfonamide group, and the compound containing two epoxy groups will be described based on specific examples. Further, each compound used in the present disclosure is not limited to the following specific examples.

As the diamine compound containing a sulfonamide group, the following compounds SAA-1 to SAA-32 are exemplified.

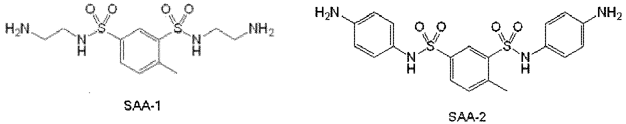

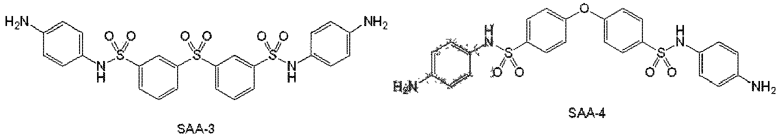

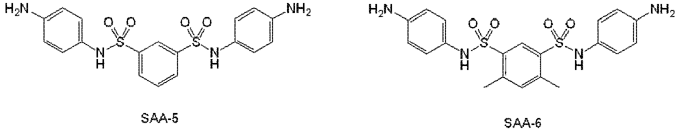

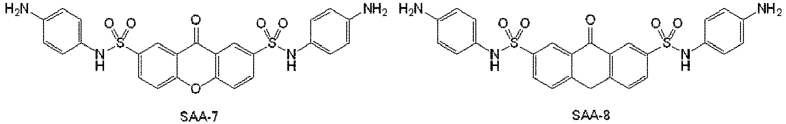

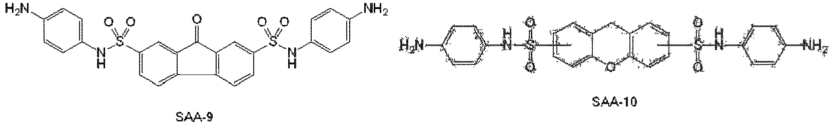

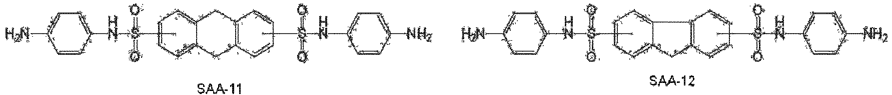

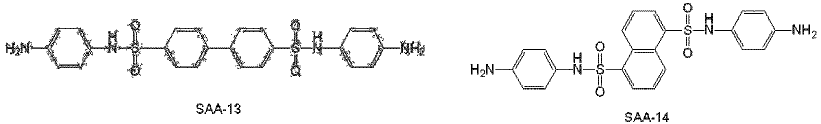

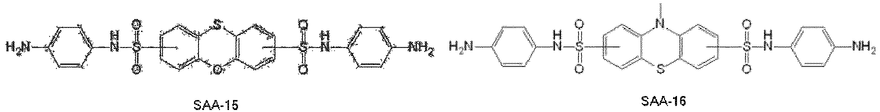

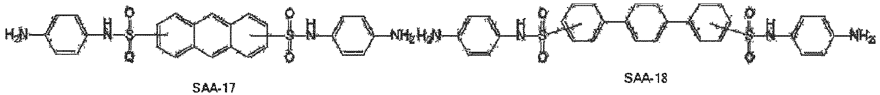

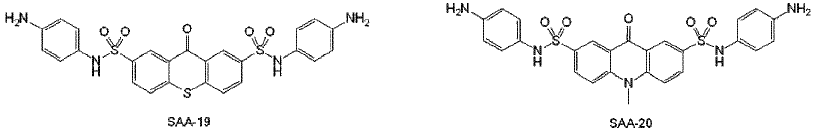

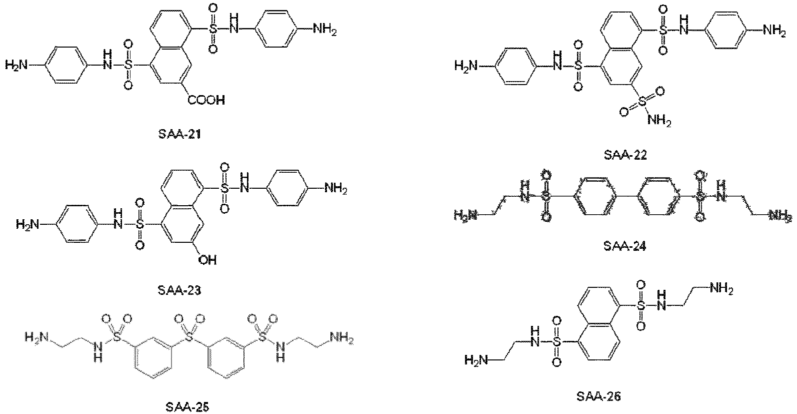

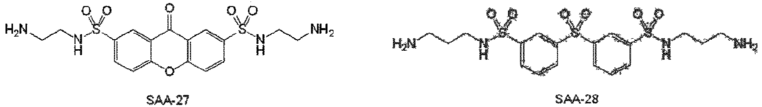

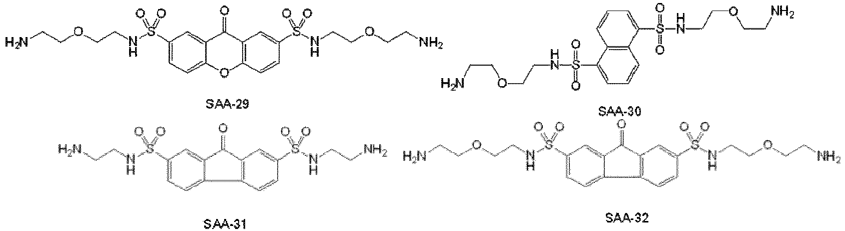

As the dithiol compound containing a sulfonamide group, the following compounds SAS-1 to SAS-11 are exemplified.

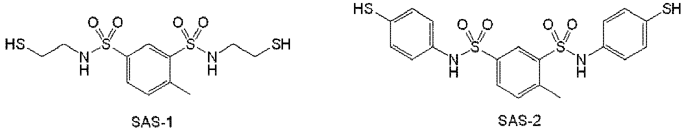

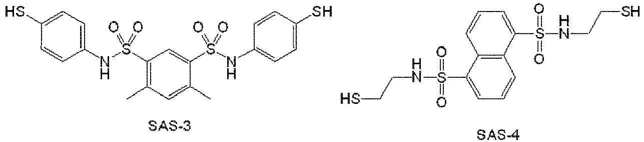

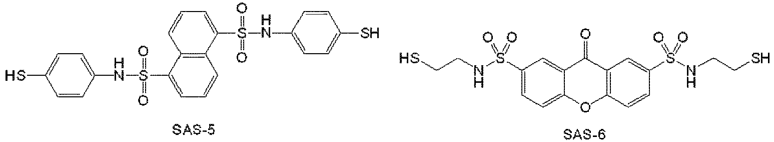

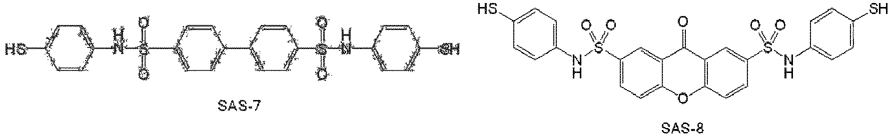

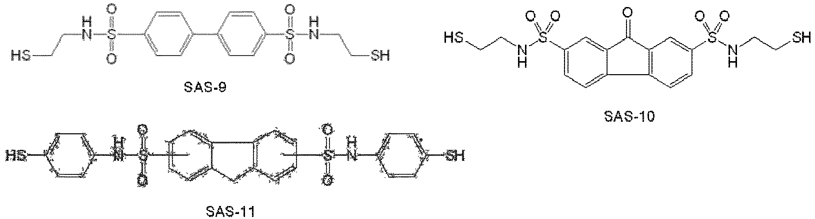

As the diol compound containing a sulfonamide group, the following compounds SAO-1 to SAO-6 are exemplified.

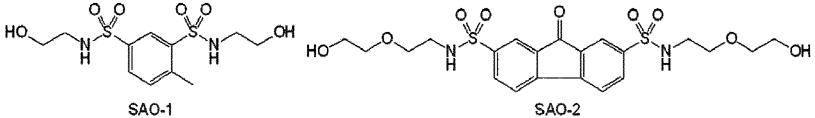

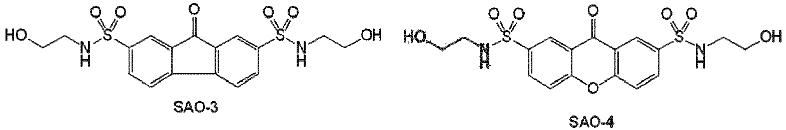

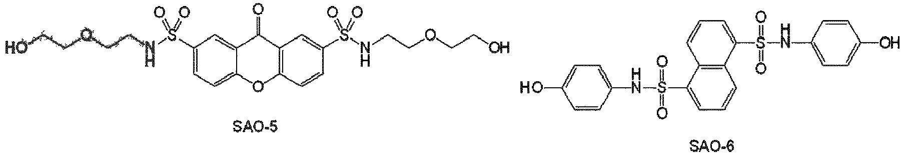

As the diamine compound that does not contain a sulfonamide group, the following compounds DA-1 to DA-41 are exemplified. In the structural formulae, m or n on the lower right side of [ ] or ( ) represents the repetition number of each repeating unit.

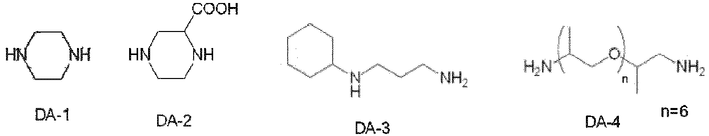

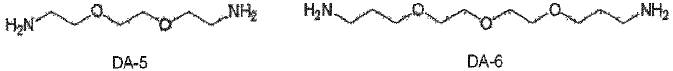

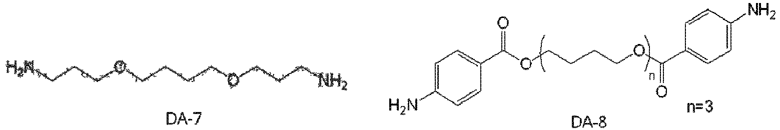

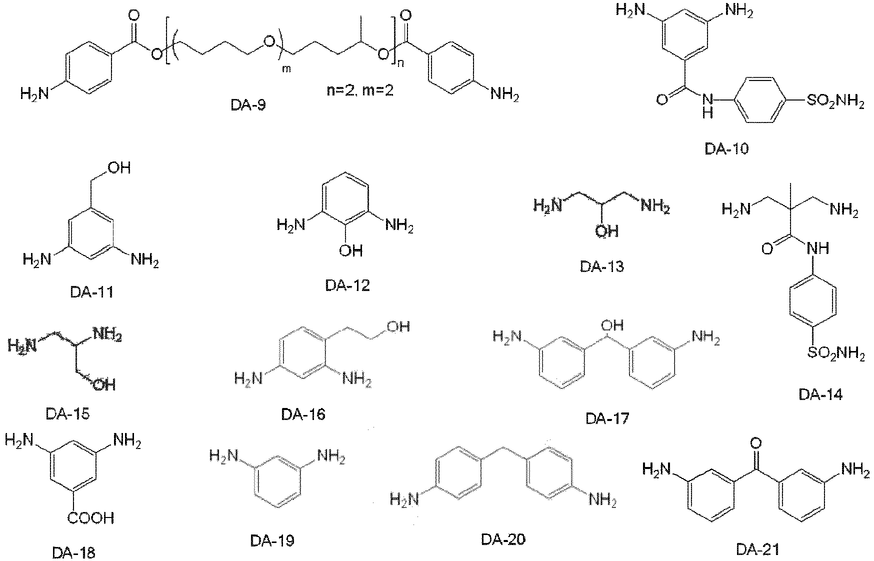

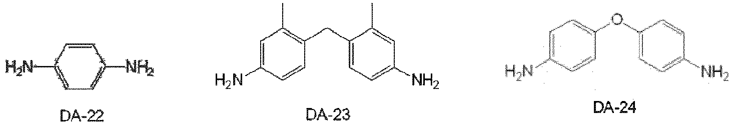

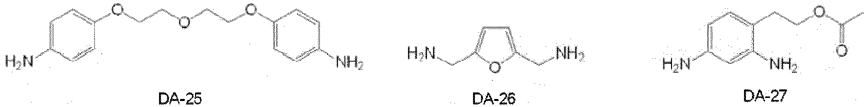

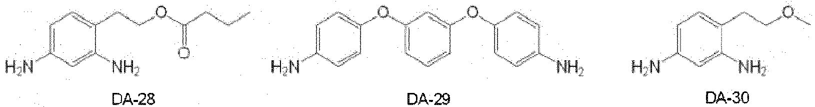

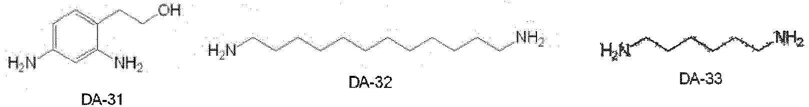

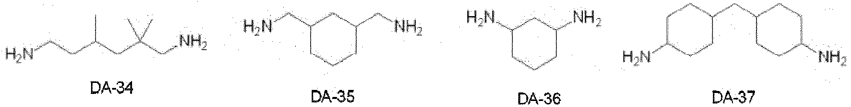

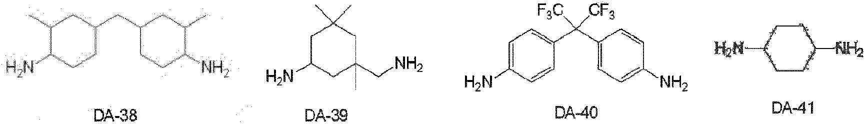

As the dithiol compound that does not contain a sulfonamide group, the following compounds DS-1 to DS-10 are exemplified.

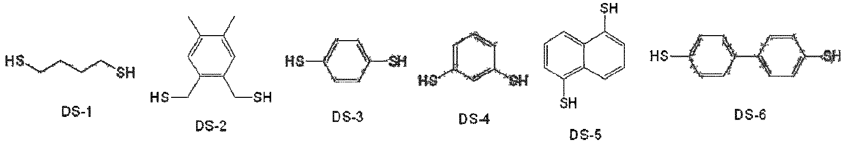

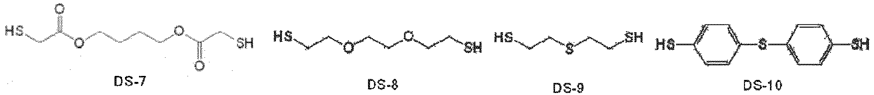

As the diol compound that does not contain a sulfonamide group, the following compounds DO-1 to DO-12 are exemplified. In the structural formulae, n on the lower right side of [ ] represents the repetition number of each repeating unit.

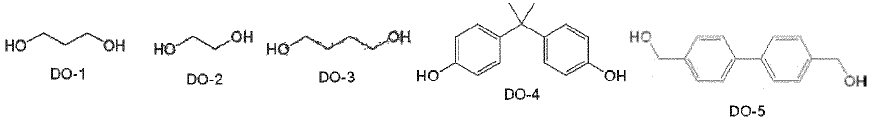

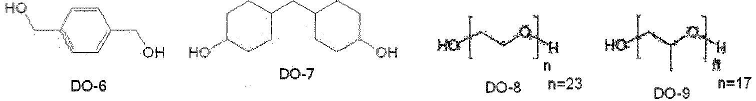

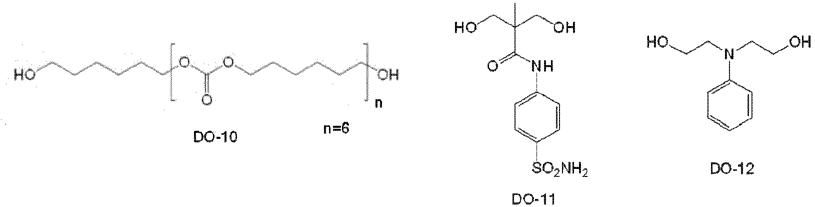

As the compound containing two epoxy groups, the following compounds DE-1 to DE-9 are exemplified. In the structural formulae, m or n on the lower right side of [ ] or ( ) represents the repetition number of each repeating unit. Further, m constitutional units and n constitutional units in compound DE-4 are randomly arranged.

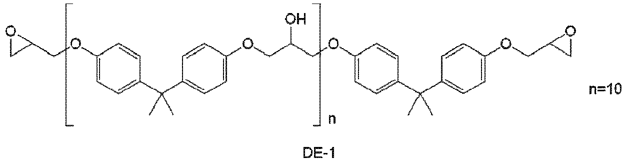

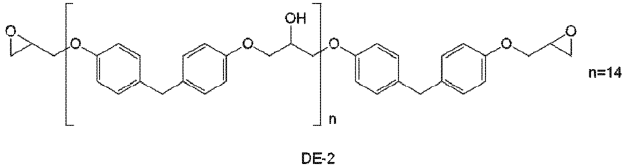

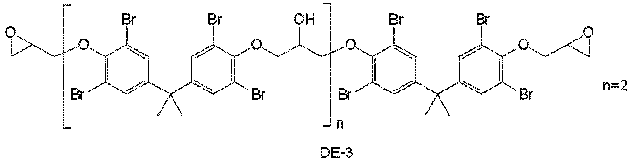

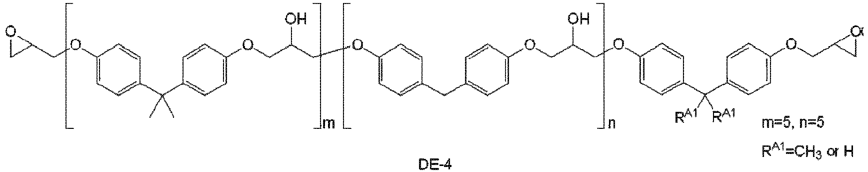

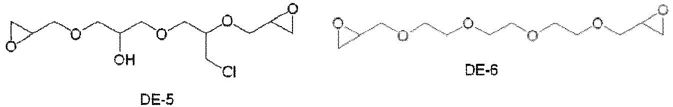

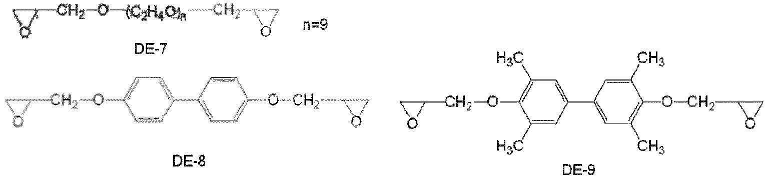

Commercially available products can be used as the compound containing two epoxy groups, and examples thereof include JER Epoxy Resin series such as JER825, JER1001, JER1055, JER1007, and JER4007P (all manufactured by Mitsubishi Chemical Corporation), EPICLON series such as EPICLON 152, EPICLON 153, EPICLON 830, and EPICLON 840 (all manufactured by DIC Corporation), EPIOL series such as EPIOL E-100LC, E-400, and E-1000 (all manufactured by NOF Corporation).

Further, the weight-average molecular weight (Mw) of the specific polymer compound used in the present disclosure is preferably in a range of 10,000 to 500,000, more preferably in a range of 10,000 to 200,000, and still more preferably in a range of 20,000 to 100,000.

In the present disclosure, the weight-average molecular weight can be calculated by a standard polystyrene conversion method using gel permeation chromatography (GPC). A column filled with a polystyrene crosslinked gel (TSKgel SuperAWM-H; manufactured by Tosoh Corporation) can be used as the GPC column, and N-methylpyrrolidone (0.01 mol/L of each of phosphoric acid and lithium bromide) can be used as the GPC solvent.

Specifically, the measurement is performed by allowing a solvent (N-methylpyrrolidone) to flow at a flow rate of 0.4 ml per minute at a temperature of 40°C and injecting 5 µl of the N-methylpyrrolidone sample solution having a concentration of 0.2 g/20 ml in terms of the sample mass.

Hereinafter, the specific polymer compound will be described based on the specific examples. Further, the specific polymer compound used in the present disclosure is not limited to the following specific examples.

Specific examples of the specific polymer compound used in the present disclosure include compounds represented by Formulae PEP-1 to PEP-25.

In Formulae PEP-1 to PEP-25, the numerical value on the lower right side of [ ] represents the molar content ratio of each constitutional unit, n or m on the lower right side of [ ] represents the repetition number of each repeating unit, the numerical value on the lower right side of ( ) represents the repetition number of the polyalkyleneoxy group, and Mw represents the weight-average molecular weight. Further, m constitutional units and n constitutional units in Formula PEP-8 are randomly arranged.

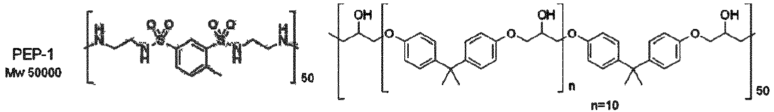

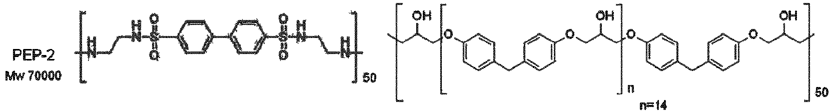

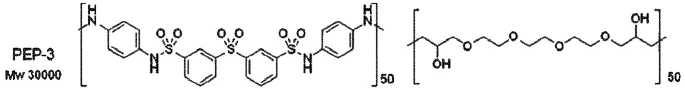

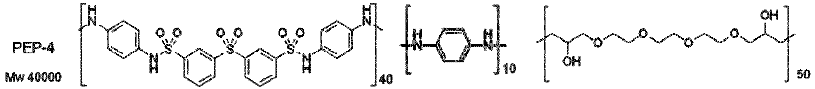

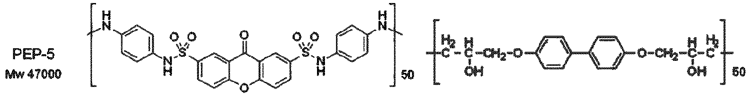

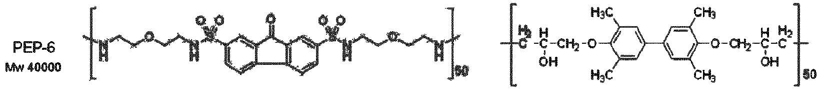

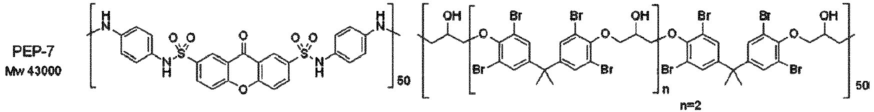

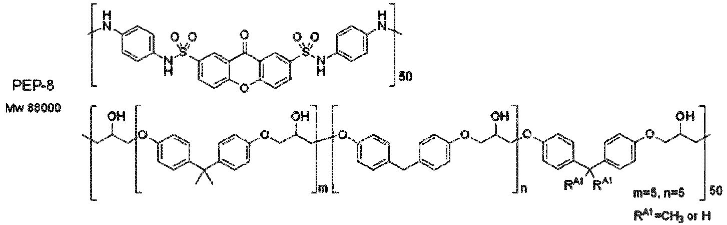

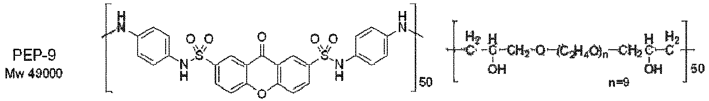

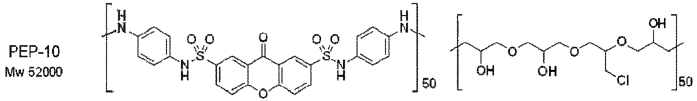

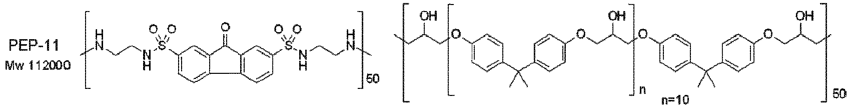

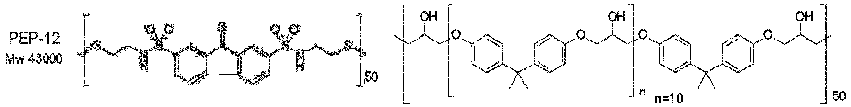

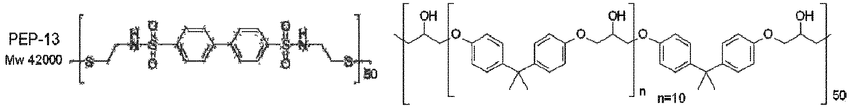

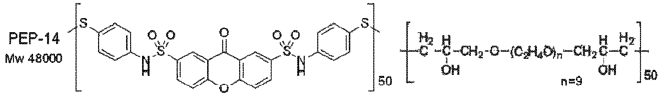

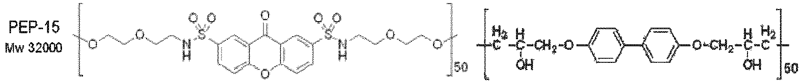

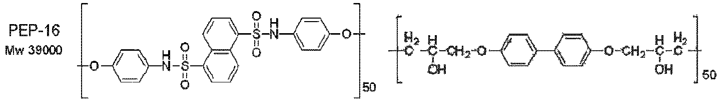

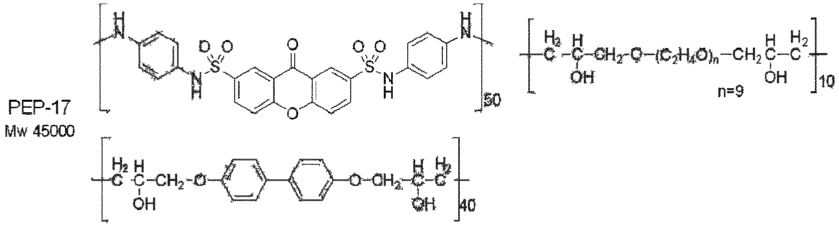

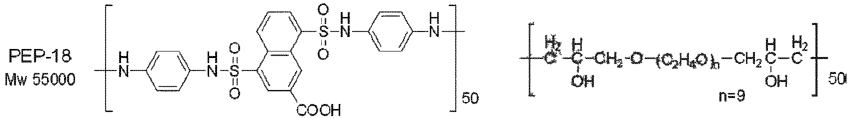

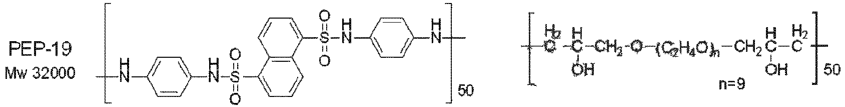

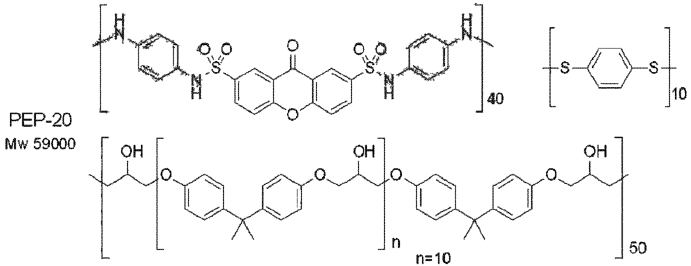

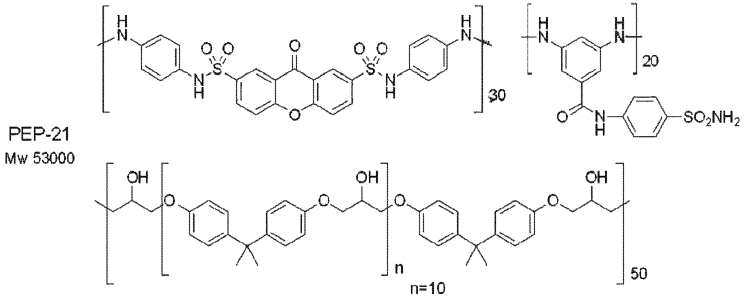

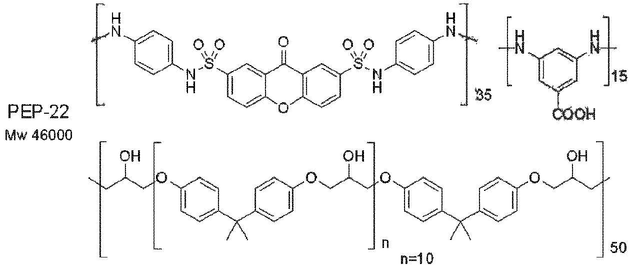

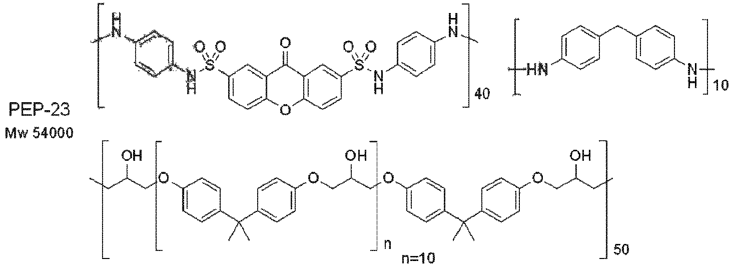

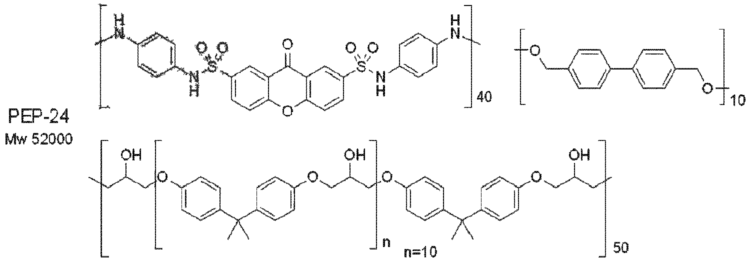

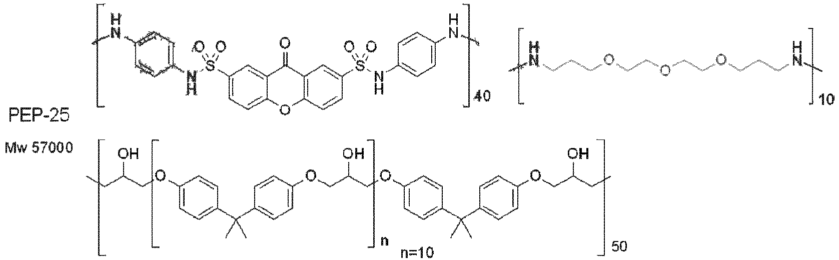

For example, the specific polymer compound represented by Formula PEP-1 can also be regarded as a specific polymer compound represented by Formula PEP-1'.

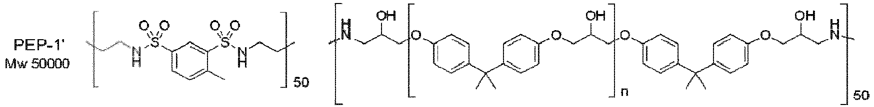

The specific polymer compound represented by any of Formulae PEP-1 to PEP-25 can be produced by a sequential polymerization reaction of a compound containing a sulfonamide group listed in Table 1, a compound that does not contain a sulfonamide group as necessary, and a compound containing two epoxy groups. In Table 1, the description of "-" indicates that the corresponding compound is not contained.

**[Table 1]**

| Specific polymer compound | Compound containing sulfonamide group | | Compound that does not contain sulfonamide group | | Compound containing two epoxy groups | | | | Weight-average molecular weight |
|---|---|---|---|---|---|---|---|---|---|
| | Compound | Content (molar ratio) | Compound | Content (molar ratio) | Compound | Content (molar ratio) | Compound | Content (molar ratio) | |
| PEP-1 | SAA-1 | 50 | - | - | DE-1 | 50 | - | - | 50,000 |
| PEP-2 | SAA-24 | 50 | - | - | DE-2 | 50 | - | - | 70,000 |
| PEP-3 | SAA-3 | 50 | - | - | DE-6 | 50 | - | - | 30,000 |
| PEP-4 | SAA-3 | 40 | DA-22 | 10 | DE-6 | 50 | - | - | 40,000 |
| PEP-5 | SAA-7 | 50 | - | - | DE-8 | 50 | - | - | 47,000 |
| PEP-6 | SAA-32 | 50 | - | - | DE-9 | 50 | - | - | 40,000 |
| PEP-7 | SAA-7 | 50 | - | - | DE-3 | 50 | - | - | 43,000 |
| PEP-8 | SAA-7 | 50 | - | - | DE-4 | 50 | - | - | 88,000 |
| PEP-9 | SAA-7 | 50 | - | - | DE-7 | 50 | - | - | 49,000 |
| PEP-10 | SAA-7 | 50 | - | - | DE-5 | 50 | - | - | 52,000 |
| PEP-11 | SAA-31 | 50 | - | - | DE-1 | 50 | - | - | 112,000 |
| PEP-1 2 | SAS-10 | 50 | - | - | DE-1 | 50 | - | - | 43,000 |
| PEP-13 | SAS-9 | 50 | - | - | DE-1 | 50 | - | - | 42,000 |
| PEP-14 | SAS-8 | 50 | - | - | DE-7 | 50 | - | - | 48,000 |
| PEP-15 | SAO-5 | 50 | - | - | DE-8 | 50 | - | - | 32,000 |
| PEP-16 | SAO-6 | 50 | - | - | DE-8 | 50 | - | - | 39,000 |
| PEP-17 | SAA-7 | 50 | - | - | DE-7 | 10 | DE-8 | 40 | 45,000 |
| PEP-18 | SAA-21 | 50 | - | - | DE-7 | 50 | - | - | 55,000 |
| PEP-19 | SAA-14 | 50 | - | - | DE-7 | 50 | - | - | 32,000 |
| PEP-20 | SAA-7 | 40 | DS-3 | 10 | DE-1 | 50 | - | - | 59,000 |
| PEP-21 | SAA-7 | 30 | DA-14 | 20 | DE-1 | 50 | - | - | 53,000 |
| PEP-22 | SAA-7 | 35 | DA-18 | 15 | DE-1 | 50 | - | - | 46,000 |
| PEP-23 | SAA-7 | 40 | DA-20 | 10 | DE-1 | 50 | - | - | 54,000 |
| PEP-24 | SAA-7 | 40 | DO-5 | 10 | DE-1 | 50 | - | - | 52,000 |
| PEP-25 | SAA-7 | 40 | DA-6 | 10 | DE-1 | 50 | - | - | 57,000 |

The content of the specific polymer compound in the positive type photosensitive resin composition according to the present disclosure is preferably in a range of 10% by mass to 90% by mass, more preferably in a range of 20% by mass to 85% by mass, and particularly preferably in a range of 30% by mass to 80% by mass with respect to the total mass of the solid content in the positive type photosensitive resin composition.

In a case where the content thereof is in the above-described range, the developability of the positive type planographic printing plate precursor to be obtained is excellent and the chemical resistance, the ink impression properties, and the printing durability of the planographic printing plate to be obtained are excellent. In addition, the total mass of the solid content in the positive type photosensitive resin composition indicates the amount obtained by removing volatile components such as a solvent.

### <Infrared absorbent>

The infrared absorbent is not particularly limited as long as it is a dye which generates heat by absorbing infrared light, and various dyes known as an infrared absorbent can be used.

Examples of the infrared absorbent which can be used in the present disclosure include the infrared absorbents described in paragraphs 0075 to 0085 of WO2016/047392A.

Among these dyes, examples of a particularly preferable dye include a cyanine coloring agent, a phthalocyanine dye, an oxonol dye, a squarylium coloring agent, a pyrylium salt, a thiopyrylium dye, and a nickel thiolate complex. Furthermore, it is most preferable that a cyanine coloring agent represented by the following Formula (a) is used for the upper layer of the positive type planographic printing plate precursor of the present disclosure from the viewpoint that the dissolution suppressing action is satisfactorily removed due to exposure and stability and economic efficiency are excellent.

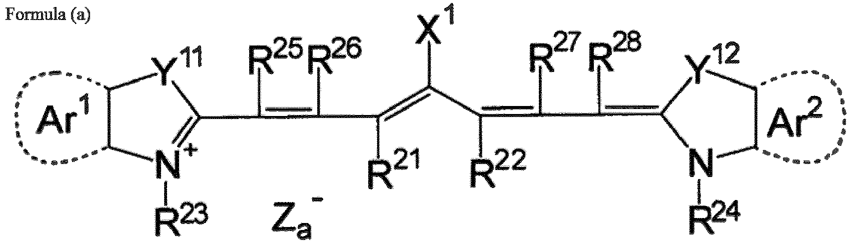

In Formula (a), X¹ represents a hydrogen atom, a halogen atom, a diarylamino group, X²-L¹, or a group shown represented by Formula (b). X² represents an oxygen atom or a sulfur atom, and L¹ represents a hydrocarbon group having 1 to 12 carbon atoms, an aromatic ring having a heteroatom, or a hydrocarbon group having 1 to 12 carbon atoms including a heteroatom. Here, the heteroatom represents N, S, O, a halogen atom, or Se.

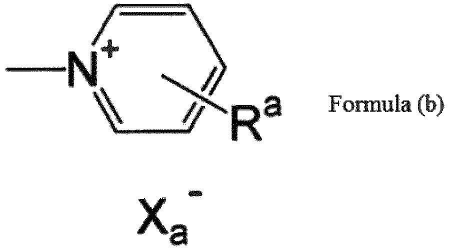

In Formula (b), Xa⁻ has the same definition as Za⁻ described below, and R^{a} represents a substituent selected from a hydrogen atom, an alkyl group, an aryl group, a substituted or unsubstituted amino group, and a halogen atom.

Each of R²¹ and R²² independently represents a hydrocarbon group having 1 to 12 carbon atoms. From the viewpoint of storage stability of the positive type photosensitive resin composition, each of R²¹ and R²² is preferably a hydrocarbon group having two or more carbon atoms, and R²¹ and R²² are particularly preferably bonded to each other to form a 5-membered ring or a 6-membered ring.

Ar¹ and Ar² may be the same as or different from each other, and Ar¹ and Ar² each represent an aromatic hydrocarbon group which may have a substituent. Examples of a preferable aromatic hydrocarbon group include a benzene ring and a naphthalene ring. In addition, examples of a preferable substituent include a hydrocarbon group having 12 or less carbon atoms, a halogen atom, and an alkoxy group having 12 or less carbon atoms.

Y¹¹ and Y¹² may be the same as or different from each other, and Y¹¹ and Y¹² each represent a sulfur atom or a dialkyl methylene group having 12 or less carbon atoms. R²³ and R²⁴ may be the same as or different from each other, and R²³ and R²⁴ each represent a hydrocarbon group having 20 or less carbon atoms which may have a substituent. Examples of a preferable substituent include an alkoxy group having 12 or less carbon atoms, a carboxyl group, and a sulfo group.

R²⁵, R²⁶, R²⁷, and R²⁸ may be the same as or different from each other, and R²⁵, R²⁶, R²⁷, and R²⁸ each represent a hydrogen atom or a hydrocarbon group having 12 or less carbon atoms. From the viewpoint of availability of a raw material, each of R²⁵, R²⁶, R²⁷, and R²⁸ is preferably a hydrogen atom. In addition, Za⁻ represents a counter anion. Here, the cyanine coloring agent represented by Formula (a) has an anionic substituent in the structure thereof, and in a case where neutralization of the charge is not necessary, Za⁻ is not necessary. From the viewpoint of storage stability of the positive type photosensitive resin composition, Za⁻ is preferably a halide ion, a perchlorate ion, a tetrafluoroborate ion, a hexafluorophosphate ion, or a sulfonate ion, and particularly preferably a perchlorate ion, a hexafluorophosphate ion, or an arylsulfonate ion.

Specific examples of the cyanine coloring agent represented by Formula (a) which can be suitably used include the cyanine coloring agents described in paragraphs 0017 to 0019 of JP2001-133969A, paragraphs 0012 to 0038 of JP2002-040638A, and paragraphs 0012 to 0023 of JP2002-023360A.

The infrared absorbent contained in the upper layer is particularly preferably a cyanine dye A shown below.

### Cyanine dye A

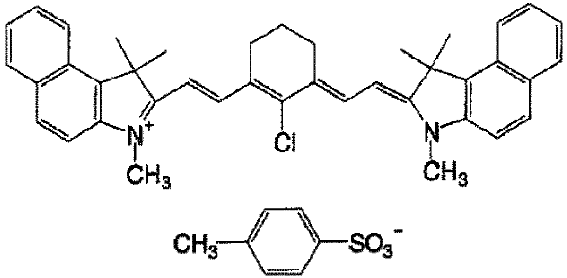

The content of the infrared absorbent in the positive type photosensitive resin composition according to the present disclosure is preferably in a range of 0.01% by mass to 50% by mass, more preferably in a range of 0.1% by mass to 30% by mass, and particularly preferably in a range of 1.0% by mass to 30% by mass, with respect to the total mass of the solid content in the positive type photosensitive resin composition. In a case where the content thereof is 0.01% by mass or greater, the layer becomes highly sensitive, and in a case where the content thereof is 50% by mass or less, the uniformity of the layer is excellent and the durability of the layer is excellent. In addition, the total mass of the solid content in the positive type photosensitive resin composition indicates the mass obtained by removing volatile components such as a solvent.

### <Other alkali-soluble resins>

In the present disclosure, the "alkali-soluble" means that "0.01 g of a resin is dissolved in 5 g of a sodium hydroxide aqueous solution having a pH of 13.0 at 30°C within 200 seconds. Further, the dissolution indicates is a state in which the residual of a dissolved substance cannot be visually confirmed.

Although the alkali-soluble resin other than the specific polymer compound used in the positive type photosensitive resin composition of the present disclosure is not particularly limited as long as the resin has a characteristic of being dissolved by contact with an alkaline developer, it is preferable that the alkali-soluble resin has an acidic functional group such as a phenolic hydroxyl group, a sulfonic acid group, a phosphoric acid group, a sulfonamide group, or an active imide group in at least one of the main chain or a side chain in the polymer, a resin including 10% by mole or greater of a monomer having such an acidic functional group imparting alkali-solubility is exemplified, and a resin including 20% by mole or greater is more preferable. In a case where the copolymerization component of the monomer imparting alkali-solubility is 10% by mole or greater, sufficient alkali-solubility is obtained, and developability is excellent.

In addition, as the alkali-soluble resin, a novolac resin is also preferably exemplified.

As the novolac resin which can be used in the positive type photosensitive resin composition of the present disclosure, novolac resins such as a phenol formaldehyde resin, an m-cresol formaldehyde resin, a p-cresol formaldehyde resin, an m-/p- mixed cresol formaldehyde resin, a phenol/cresol (which may be any mixture of m-, p-, or m-/p-) mixed formaldehyde resin or pyrogallol acetone resins are preferably exemplified.

In addition, a polycondensate of phenol having an alkyl group having 3 to 8 carbon atoms as a substituent and formaldehyde, such as a t-butyl phenol formaldehyde resin or an octyl phenol formaldehyde resin, as described in US4123279A, is exemplified. In addition, the weight-average molecular weight (Mw) thereof is preferably 500 or greater, and more preferably 1,000 to 700,000. In addition, the number average molecular weight (Mn) thereof is preferably 500 or greater, and more preferably 750 to 650,000. The dispersity (weight-average molecular weight/number average molecular weight) is preferably 1.1 to 10.

Other alkali-soluble resins preferably have a weight-average molecular weight of 2,000 or greater and a number average molecular weight of 500 or greater, and more preferably have a weight-average molecular weight of 5,000 to 300,000 and a number average molecular weight of 800 to 250,000. The dispersity (weight-average molecular weight/number average molecular weight) of other alkali-soluble resins is preferably 1.1 to 10.

Other alkali-soluble resins included in the positive type photosensitive resin composition according to the present disclosure as desired may be used alone or in combination of two or more kinds thereof.

The content of other alkali-soluble resins in the positive type photosensitive resin composition according to the present disclosure is preferably 0% by mass to 80% by mass and more preferably 0% by mass to 70% by mass with respect to the total mass of the solid content in the positive type photosensitive resin composition. In addition, it is preferable that the other alkali-soluble resin is contained in the proportion of 80 parts by mass or less with respect to 100 parts by mass of the specific polymer compound used in the positive type photosensitive resin composition of the present disclosure.

### <Acid generator>

It is preferable that the positive type photosensitive resin composition according to the present disclosure contains an acid generator from the viewpoint of improving the sensitivity.

The acid generator in the present disclosure is a compound which generates an acid by light or heat, and indicates a compound which generates an acid due to decomposition by irradiation with infrared rays or heating at 100°C or higher. The acid generated is preferably a strong acid having a pKa of 2 or less such as sulfonic acid or hydrochloric acid. The permeability of a developer into the image recording layer of the exposed portion is increased and the solubility of the image recording layer in an alkali aqueous solution is further improved due to an acid generated from this acid generator.

Examples of the acid generator which is suitably used in the positive type photosensitive resin composition of the present disclosure include the acid generators described in paragraphs 0116 to 0130 of WO2016/047392A.

Among these, from the viewpoint of sensitivity and stability, an onium salt compound is preferably used as an acid generator. The onium salt compound will be described below.

As the onium salt compound which can be suitably used in the positive type photosensitive resin composition of the present disclosure, compounds known as a compound which generates an acid due to decomposition by infrared ray exposure or heat energy generated from the infrared absorbent by exposure can be exemplified. As the onium salt compound suitable in the positive type photosensitive resin composition of the present disclosure, from the viewpoint of sensitivity, known thermal polymerization initiators or compounds having a bond with small bond dissociation energy and having an onium salt structure described below can be exemplified.

Examples of the onium salt suitably used in the positive type photosensitive resin composition of the present disclosure include known diazonium salts, iodonium salts, sulfonium salts, ammonium salts, pyridinium salts, and azinium salts, and among these, sulfonate of triarylsulfonium or diaryliodonium, carboxylate, BF₄⁻, PF₆⁻, or ClO₄⁻ is preferable.

Examples of the onium salt which can be used as an acid generator in the positive type photosensitive resin composition of the present disclosure include onium salts represented by the following Formulae (III) to (V).

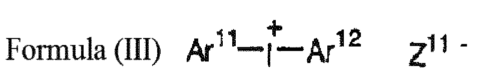

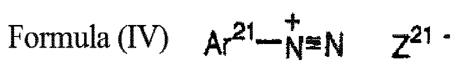

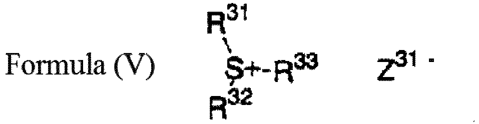

In Formula (III), each of Ar¹¹ and Ar¹² independently represents an aryl group having 20 or less carbon atoms which may have a substituent. Examples of a preferable substituent in a case where the aryl group has a substituent include a halogen atom, a nitro group, an alkyl group having 12 or less carbon atoms, an alkoxy group having 12 or less carbon atoms, and an aryloxy group having 12 or less carbon atoms. Z¹¹⁻ represents a counter ion selected from the group consisting of a halide ion, a perchlorate ion, a tetrafluoroborate ion, a hexafluorophosphate ion, a sulfonate ion, or a sulfonate ion having a fluorine atom such as a perfluoroalkyl sulfonate ion, and a perchlorate ion, a hexafluorophosphate ion, an aryl sulfonate ion, or a perfluoroalkyl sulfonic acid is preferable.

In Formula (IV), Ar²¹ represents an aryl group having 20 or less carbon atoms which may have a substituent. Examples of a preferable substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. Z²¹⁻ represents a counter ion having the same definition as that for Z¹¹⁻.

In Formula (V), R³¹, R³², and R³³ may be the same as or different from each other, and R³¹, R³², and R³³ each represent a hydrocarbon group having 20 or less carbon atoms which may have a substituent. Examples of a preferable substituent include a halogen atom, a nitro group, an alkyl group having 12 or less carbon atoms, an alkoxy group having 12 or less carbon atoms, and an aryloxy group having 12 or less carbon atoms. Z³¹⁻ represents a counter ion having the same definition as that for Z¹¹⁻.

Specific examples of the onium salt which can be suitably used in the positive type photosensitive resin composition according to the present disclosure are the same as the compounds described in paragraphs 0121 to 0124 of WO2016/047392A.

In addition, as another example of the compounds represented by each of Formula (III) to (V), the compounds described as an example of a radical polymerization initiator in paragraphs 0036 to 0045 of JP2008-195018A can be suitably used as an acid generator in the positive type photosensitive resin composition of the present disclosure.

More preferred examples of the acid generator which can be used in the positive type photosensitive resin composition of the present disclosure include compounds represented by Formulae PAG-1 to PAG-5. Further, in Formulae PAG-1 to PAG-5, Me represents a methyl group.

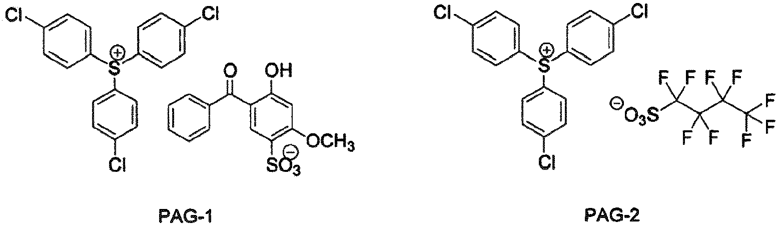

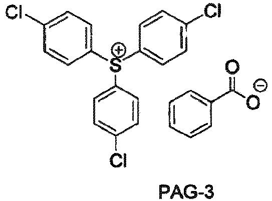

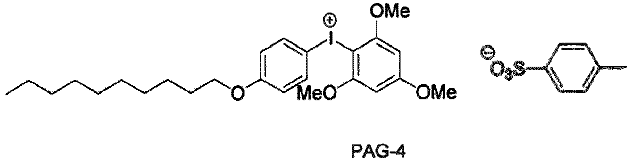

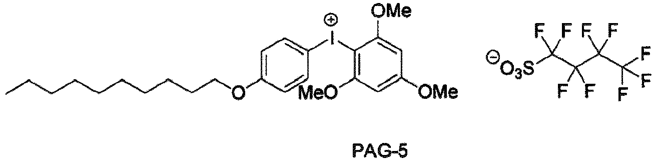

In a case where these acid generators are contained in the positive type photosensitive resin composition according to the present disclosure, these compounds may be used alone or in combination of two or more kinds thereof.

The content of acid generator is in a range of 0.01% by mass to 50% by mass, preferably in a range of 0.1% by mass to 40% by mass, and more preferably in a range of 0.5% by mass to 30% by mass with respect to the total mass of the solid content in the positive type photosensitive resin composition. In a case where the content is within the above-described range, improvement of sensitivity which is the effect of the addition of an acid generator is observed, and an occurrence of a residual film in a non-image area is suppressed.

### <Acid proliferation agent>

An acid proliferation agent may be contained in the positive type photosensitive resin composition of the present disclosure. The acid proliferation agent in the positive type photosensitive resin composition of the present disclosure is a compound substituted with a residue of a relatively strong acid, and a compound which newly generates an acid by being easily released in the presence of an acid catalyst. That is, the compound is decomposed by an acid catalyzed reaction, and generates an acid again. Since one or more acids per reaction are increased, and with the progress of the reaction, the acid concentration is increasingly increased, sensitivity is dramatically improved. The intensity of this generated acid preferably is 3 or less as an acid dissociation constant (pKa) and more preferably 2 or less. In a case where the intensity of the acid is 3 or less as an acid dissociation constant, the elimination reaction using an acid catalyst is likely to be caused.

Examples of the acid used in such an acid catalyst include dichloroacetic acid, trichloroacetic acid, methanesulfonic acid, ethanesulfonic acid, benzenesulfonic acid, p-toluenesulfonic acid, naphthalenesulfonic acid, and phenyl sulfonic acid.

Examples of the acid proliferation agent which can be used are the same as those described in paragraphs 0133 to 0135 of WO2016/047392A.

The content of the acid proliferation agent is in a range of 0.01% by mass to 20% by mass, preferably in a range of 0.01% by mass to 10% by mass, and more preferably in a range of 0.1% by mass to 5% by mass with respect to the total mass of the solid content of the positive type photosensitive resin composition. In a case where the content of the acid proliferation agent is in the above-described range, effects of adding acid proliferation agent are sufficiently obtained, improvement in sensitivity is achieved, and film hardness reduction of an image area is suppressed.

### <Other additives>

The positive type photosensitive resin composition according to the present disclosure may include a development accelerator, a surfactant, a print-out agent/colorant, a plasticizer, or a wax agent, as other additives. As other additives, those described in paragraphs 0138 to 0142 of WO2016/047392A can be used.

### <Compositional ratio of respective components>

The content of the specific polymer compound is preferably 10% by mass to 90% by mass, the content of the infrared absorbent is preferably 0.01% by mass to 50% by mass, the content of other alkali-soluble resins is preferably 0% by mass to 80% by mass, the content of the acid generator is preferably 0% by mass to 30% by mass, the content of the acid proliferation agent is preferably 0% by mass to 20% by mass, the content of the development accelerator is preferably 0% by mass to 20% by mass, the content of the surfactant is preferably 0% by mass to 5% by mass, the content of the print-out agent/colorant is preferably 0% by mass to 10% by mass, the content of the plasticizer is preferably 0% by mass to 10% by mass, and the content of the wax agent is preferably 0% by mass to 10% by mass, with respect to the total mass of the solid content of the positive type photosensitive resin composition according to the present disclosure.

The positive type photosensitive resin composition according to the present disclosure can be applied to various fields requiring resin pattern formation excellent in durability, for example, various fields such as a resist, a display, a planographic printing plate precursor, and the like, and since the photosensitive resin composition can be recorded with high sensitivity and has excellent image formability, and the durability of the image area formed of the composition is excellent, by applying to the positive type planographic printing plate precursor described in detail below, the effects of the positive type photosensitive resin composition of the present disclosure can become significant.

### (Positive type planographic printing plate precursor)

The positive type planographic printing plate precursor according to the present disclosure has an image recording layer containing the positive type photosensitive resin composition according to the present disclosure, on a support having a hydrophilic surface.

Further, the image recording layer has a lower layer and an upper layer from the side of the support, it is preferable that the at least one of the lower layer or the upper layer contains the positive type photosensitive resin composition, more preferable that the lower layer or the upper layer contains the positive type photosensitive resin composition, and still more preferable that only the lower layer contains the positive type photosensitive resin composition.

### <Image recording layer>

The image recording layer included in the positive type planographic printing plate precursor of the present disclosure can be formed by dissolving respective components of the positive type photosensitive resin composition of the present disclosure in a solvent and applying the resulting product to a suitable support.

Examples of the solvent used here include ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl urea, N-methylpyrrolidone, dimethyl sulfoxide, sulfolane, γ-butyrolactone, and toluene, and the present invention is not limited thereto. These solvents are used alone or in a mixture.

### <Formation of lower layer and upper layer>

In addition, it is preferable that the positive type planographic printing plate precursor of the present disclosure is a positive type planographic printing plate precursor (hereinafter, also referred to as a "positive type planographic printing plate precursor having a two-layer structure") including an image recording layer that has a lower layer and an upper layer in this order, on the support.

The lower layer and the upper layer are preferably separately formed in principle.

As the method of separately forming the two layers, for example, a method of using the difference in the solvent solubilities between the components included in the lower layer and the components included in the upper layer and a method of rapidly drying and removing the solvent after application to the upper layer are exemplified. Since by using the latter method in combination, the separation between the layers is more favorably performed, the method is preferable.

These methods will be described in detail below, but the method of separately applying to the two layers is not limited thereto.

In the method of using the difference in the solvent solubilities between the components included in the lower layer and the components included in the upper layer, in a case where applying a coating solution for an upper layer, a solvent system in which all the components included in the lower layer are insoluble is used. Thus, even in a case where two-layer coating is performed, a coating film can be formed such that each layer thereof is clearly separated. For example, by selecting a component insoluble in a solvent such as methyl ethyl ketone or 1-methoxy-2-propanol which dissolves an alkali-soluble resin which is the upper layer component, as the lower layer component, applying to the lower layer and drying using a solvent system which dissolves the lower layer component, dissolving the alkali-soluble resin-based upper layer in methyl ethyl ketone or 1-methoxy-2-propanol, and applying the resulting product and drying, bilayering is possible.

Next, the method of very rapidly drying the solvent after application to the second layer (upper layer) can be achieved by blowing high-pressure air from a slit nozzle provided substantially at a right angle with respect to the running direction of the web, applying heat energy as conductive heat from the lower surface of the web by a roll (heating roll) into which a heating medium such as steam has been supplied, or combining these.

The positive type photosensitive resin composition according to the present disclosure is preferably included in at least one of the upper layer or the lower layer and more preferably included only in the lower layer.

The coating amount after drying of the lower layer components to be applied to the support of the positive type planographic printing plate precursor according to the present disclosure is preferably in a range of 0.5 g/m² to 4.0 g/m² and more preferably in a range of 0.6 g/m² to 2.5 g/m². In a case where the coating amount is 0.5 g/m² or greater, printing durability is excellent, and in a case where the coating amount is 4.0 g/m² or less, image reproducibility and sensitivity are excellent.

In addition, the coating amount after drying of the upper layer component is preferably 0.05 g/m² to 1.0 g/m² and more preferably 0.08 g/m² to 0.7 g/m². In a case where the coating amount is 0.05 g/m² or greater, development latitude and scratch resistance are excellent, and in a case where the coating amount is 1.0 g/m² or less, sensitivity is excellent.

The coating amount after drying of the lower layer and the upper layer is preferably in a range of 0.6 g/m² to 4.0 g/m² and more preferably in a range of 0.7 g/m² to 2.5 g/m². In a case where the coating amount is 0.6 g/m² or greater, printing durability is excellent, and in a case where the coating amount is 4.0 g/m² or less, image reproducibility and sensitivity are excellent.

### <Upper layer>

The upper layer of the positive type planographic printing plate precursor having a two-layer structure according to the present disclosure may be a layer containing the positive type photosensitive resin composition of the present disclosure, but it is preferable that the upper layer thereof is a layer containing other resin compositions other than the positive type photosensitive resin composition according to the present disclosure.

It is preferable that the upper layer of the positive type planographic printing plate precursor having a two-layer structure according to the present disclosure is an infrared sensitive positive type image recording layer whose solubility in an alkali aqueous solution is improved by heat.

The mechanism of improving the solubility in alkali aqueous solution by heat in the upper layer is not particularly limited, and any one can be used as long as it includes a binder resin and improves the solubility of the heated region. As the heat used in image formation, the heat generated in a case where the lower layer including an infrared absorbent is exposed is exemplified.

Preferable examples of the upper layer of which the solubility in an alkali aqueous solution is improved by heat include a layer including an alkali-soluble resin having a hydrogen-bonding capacity such as novolac or urethane, a layer including a water-insoluble and alkali-soluble resin and a compound having a dissolution suppressing action, and a layer including an ablation-possible compound.

In addition, by further adding an infrared absorbent to the upper layer, the heat generated from the upper layer can also be used in image formation. Preferable examples of the constitution of the upper layer including an infrared absorbent include a layer including an infrared absorbent, a water-insoluble and alkali-soluble resin, and a compound having a dissolution suppressing action, and a layer including an infrared absorbent, a water-insoluble and alkali-soluble resin, and an acid generator.

### [Water-insoluble and alkali-soluble resin]

In the present disclosure, the "alkali-soluble" means that "0.01 g of a resin is dissolved in 5 g of a sodium hydroxide aqueous solution having a pH of 13.0 at 30°C within 200 seconds. Further, the dissolution indicates is a state in which the residual of a dissolved substance cannot be visually confirmed.

It is preferable that the upper layer of the positive type planographic printing plate precursor having a two-layer structure according to the present disclosure contains a water-insoluble and alkali-soluble resin. By containing the water-insoluble and alkali-soluble resin, an interaction is formed between the polar groups of the infrared absorbent and the water-insoluble and alkali-soluble resin, and a layer having a positive type photosensitivity is formed.

Typical water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

The water-insoluble and alkali-soluble resin is not particularly limited as long as it has a characteristic of being dissolved by contact with an alkaline developer, and a homopolymer containing an acidic group in at least one of the main chain or a side chain in the polymer, a copolymer thereof, or a mixture thereof is preferable.

Such a water-insoluble and alkali-soluble resin having an acidic group preferably has a functional group such as a phenolic hydroxyl group, a carboxyl group, a sulfonic acid group, a phosphoric acid group, a sulfonamide group, or an active imide group. Therefore, such a resin can be suitably produced by copolymerizing a monomer mixture including one or more ethylenically unsaturated monomers having a functional group described above. As the ethylenically unsaturated monomer having a functional group described above, in addition to acrylic acid and methacrylic acid, a compound represented by the following formula and a mixture thereof can be preferably exemplified. Moreover, in the following formula, R⁴⁰ represents a hydrogen atom or a methyl group.

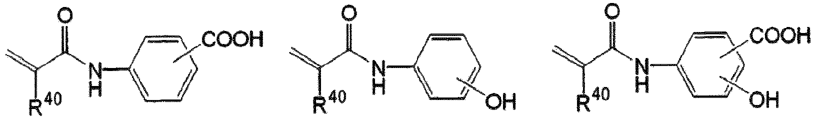

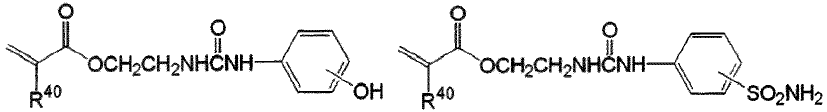

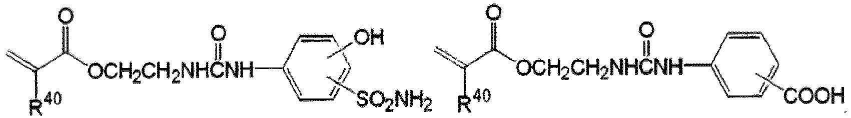

The water-insoluble and alkali-soluble resin is preferably a polymer compound obtained by copolymerizing another polymerizable monomer in addition to the above-mentioned polymerizable monomers. As the copolymerization ratio in this case, a monomer imparting alkali-solubility such as a monomer having a functional group such as a phenolic hydroxyl group, a carboxyl group, a sulfonic acid group, a phosphoric acid group, a sulfonamide group, or an active imide group is preferably included in 10% by mole or greater, and more preferably included in 20% by mole or greater. In a case where the copolymerization component of the monomer imparting alkali-solubility is 10% by mole or greater, sufficient alkali-solubility is obtained, and developability is excellent.

Examples of other usable polymerizable monomers include compounds exemplified below.

Alkyl acrylates or alkyl methacrylates such as methyl acrylate, ethyl acrylate, propyl acrylate, benzyl acrylate, methyl methacrylate, ethyl methacrylate, cyclohexyl methacrylate, and benzyl methacrylate. Acrylic acid esters or methacrylic acid esters having an aliphatic hydroxyl group such as 2-hydroxyethyl acrylate and 2-hydroxyethyl methacrylate. Acrylamides or methacrylamides such as acrylamide, methacrylamide, N-methylacrylamide, N-ethylacrylamide, and N-phenylacrylamide. Vinyl esters such as vinyl acetate, vinyl chloroacetate, vinyl butyrate, and vinyl benzoate. Styrenes such as styrene, α-methylstyrene, methylstyrene, and chloromethylstyrene. Other nitrogen atom-containing monomers such as N-vinyl pyrrolidone, N-vinyl pyridine, acrylonitrile, and methacrylonitrile. Maleimides such as N-methylmaleimide, N-ethylmaleimide, N-propylmaleimide, N-butylmaleimide, N-phenylmaleimide, N-2-methylphenylmaleimide, N-2,6-diethylphenylmaleimide, N-2-chlorophenylmaleimide, N-cyclohexylmaleimide, N-laurylmaleimide, and N-hydroxyphenylmaleimide.

Among these other ethylenically unsaturated monomers, (meth)acrylic acid esters, (meth)acrylamides, maleimides, or (meth)acrylonitrile is suitably used.

In addition, as the alkali-soluble resin, a novolac resin exemplified as another alkali-soluble resin described as an optional component of the positive type photosensitive resin composition according to the present disclosure may also be preferably exemplified.

In addition, the water-insoluble and alkali-soluble resin described above can also be used in the positive type photosensitive resin composition according to the present disclosure.

Furthermore, in the upper layer of the positive type planographic printing plate precursor having a two-layer structure according to the present disclosure, other resins can be used in combination within a range not impairing the effects of the positive type planographic printing plate precursor according to the present disclosure. Since the upper layer is required to express alkali-solubility, in particular, in a non-image area region, it is necessary to select a resin which does not impair this characteristic. From this viewpoint, as a resin usable in combination, a water-insoluble and alkali-soluble resin is exemplified. General water-insoluble and alkali-soluble resin will be described below in detail, and among these, a polyamide resin, an epoxy resin, a polyacetal resin, an acrylic resin, a methacrylic resin, a polystyrene-based resin, and a novolac-type phenolic resin are preferably exemplified.

In addition, the amount to be mixed is preferably 50% by mass or less with respect to the water-insoluble and alkali-soluble resin.

The water-insoluble and alkali-soluble resin preferably has a weight-average molecular weight of 2,000 or greater and a number average molecular weight of 500 or greater, and more preferably has a weight-average molecular weight of 5,000 to 300,000 and a number average molecular weight of 800 to 250,000. The dispersity (weight-average molecular weight/number average molecular weight) of the alkali-soluble resin is preferably 1.1 to 10.

The water-insoluble and alkali-soluble resin may be used alone or in combination of two or more kinds thereof.

The content of the water-insoluble and alkali-soluble resin is preferably 2.0% by mass to 99.5% by mass, more preferably 10.0% by mass to 99.0% by mass, and still more preferably 20.0% by mass to 90.0% by mass with respect to the total mass of the solid content in the upper layer of the positive type planographic printing plate precursor having a two-layer structure according to the present disclosure. In a case where the content of the alkali-soluble resin is 2.0% by mass or greater, the durability of the image recording layer (photosensitive layer) is excellent. Further, in a case where the content of the alkali-soluble resin is 99.5% by mass or less, both the sensitivity and the durability are excellent.

### [Infrared absorbent]

The upper layer may contain an infrared absorbent.

The infrared absorbent is not particularly limited as long as it is a dye which generates heat by absorbing infrared light, and the infrared absorbent used in the positive type photosensitive resin composition according to the present disclosure, described above, can also be used.

A particularly preferred dye is the cyanine dye represented by Formula (a).

In a case where the upper layer contains an infrared absorbent, a positive type planographic printing plate precursor having excellent image formability is obtained.

The content of the infrared absorbent in the upper layer is preferably 0.01% by mass to 50% by mass, more preferably 0.1% by mass to 30% by mass, and particularly preferably 1.0% by mass to 10% by mass, with respect to the total mass of the solid content in the upper layer. In a case where the content thereof is 0.01% by mass or greater, the sensitivity is improved, and in a case where the content thereof is 50% by mass or less, the uniformity of the layer is excellent and the durability of the layer is excellent.

### [Other components]

In addition, the upper layer of the positive type planographic printing plate precursor having a two-layer structure may include an acid generator, an acid proliferation agent, a development accelerator, a surfactant, a print-out agent, a colorant, a plasticizer, or a wax agent.

As these components, respective components used in the positive type photosensitive resin composition according to the present disclosure, described above, can also be used, and the preferable aspects thereof are the same as described above.

### <Lower layer>

It is preferable that the lower layer of the positive type planographic printing plate precursor having a two-layer structure in the present disclosure is a layer containing the positive type photosensitive resin composition according to the present disclosure.

Further, it is preferable that the lower layer of the positive type planographic printing plate precursor having a two-layer structure in the present disclosure is formed by applying the positive type photosensitive resin composition according to the present disclosure.

By using the positive type photosensitive resin composition according to the present disclosure for the lower layer, a printing plate with excellent image formability and printing durability can be obtained.

By using the positive type photosensitive resin composition according to the present disclosure for the lower layer, the printing durability is improved in a case where materials such as an ink and paper having particularly poor quality are used.

Though the detailed mechanism by which the effects as described above are obtained is unclear, it is assumed that for the printing durability in printing, the film hardness of the resin used in the lower layer is important, and thus, it is assumed that, since the interaction (hydrogen bonding or the like) between the binders is strong, by using the positive type photosensitive resin composition according to the present disclosure having a high film hardness in the lower layer, the printing durability is improved.

In a case where the positive type photosensitive resin composition according to the present disclosure is used in the upper layer, it is preferable that the lower layer is also formed of the positive type photosensitive resin composition according to the present disclosure, but the lower layer may be formed using a resin composition other than the positive type photosensitive resin composition according to the present disclosure. A preferable aspect of the lower layer in this case is the same as the preferable aspect of the upper layer described above.

### <Support>

The support used in the positive type planographic printing plate precursor according to the present disclosure is not particularly limited as long as the support is a dimensionally stable plate-shaped material having required strength and durability, and examples thereof include the supports described in paragraphs 0166 to 0169 of WO2016/047392A.

### <Undercoat layer>

It is preferable that the positive type planographic printing plate precursor of the present disclosure includes an undercoat layer between the support having a hydrophilic surface and the image recording layer.

As the undercoat layer component, various organic compounds can be used, and preferable examples thereof include phosphonic acids having an amino group such as carboxymethyl cellulose or dextrin, an organic phosphonic acid, an organic phosphorus acid, an organic phosphinic acid, amino acids, and hydrochloride of an amine having a hydroxyl group. In addition, these undercoat layer components may be used alone or in a mixture of two or more types thereof. Details of the compound used in the undercoat layer and the method of forming the undercoat layer are described in paragraphs 0171 and 0172 of JP2009-175195A, and those described here are also applied to the present disclosure.

The coating amount of the undercoat layer is preferably in a range of 2 mg/m² to 200 mg/m² and more preferably in a range of 5 mg/m² to 100 mg/m². In a case where the coating amount is in the above-described range, sufficient printing durability is obtained.

### <Back coat layer>

A back coat layer is provided on the rear surface of the support of the positive type planographic printing plate precursor according to the present disclosure, as necessary. As the back coat layer, coating layers formed of an organic polymer compound described in JP1993-045885A (JP-H05-045885A) or a metal oxide obtained by hydrolyzing and polycondensing an organic or inorganic metal compound described in JP1994-035174A (JP-H06-035174A) are preferably used. Among these coating layers, alkoxy compounds of silicon such as Si(OCH₃)₄, Si(OC₂H₅)₄, Si(OC₃H₇)₄, and Si(OC₄H₉)₄ are easily available at low cost, and coating layers of metal oxides obtained from these have excellent developer resistance, and thus, these are particularly preferable.

### (Method of preparing planographic printing plate)

A method of preparing the planographic printing plate according to the present disclosure includes: an exposure step of subjecting the positive type planographic printing plate precursor according to the present disclosure to image-wise exposure; and a development step of subjecting the exposed positive type planographic printing plate precursor to development using an alkali aqueous solution having a pH of 8.5 to 13.5, in this order. According to the method of preparing the planographic printing plate of the present disclosure, developability change is small, and stain caused by the residual film of a non-image area does not occur and the strength and the durability of the image area are excellent in the obtained planographic printing plate.

Hereinafter, each step of the method of preparing a planographic printing plate according to the present disclosure will be described in detail.

### <Exposure step>

The method of preparing the planographic printing plate according to the present disclosure includes an exposure step of image-exposing the positive type planographic printing plate precursor according to the present disclosure. The detailed description is the same as the description in paragraphs 0173 to 0175 of WO2016/047392A.

### <Development step>

The method of preparing the planographic printing plate according to the present disclosure includes a development step of performing development using an alkali aqueous solution with a pH of 8.5 to 13.5 (hereinafter, also referred to as a "developer").

The developer used in the development step is an aqueous solution having a pH of 8.5 to 13.5 and more preferably an alkali aqueous solution having a pH of 12 to 13.5. The surfactant contributes to improvement of the processability.

Further, it is preferable that the developer contains a surfactant and more preferable that the developer contains at least an anionic surfactant or a nonionic surfactant. A surfactant contributes to improvement of processability.

As the surfactant used in the developer, any of an anionic surfactant, a nonionic surfactant, a cationic surfactant, and an amphoteric surfactant can be used, and as described above, an anionic surfactant or a nonionic surfactant is preferable.

As the anionic surfactant, the nonionic surfactant, the cationic surfactant, and the amphoteric surfactant used in the developer according to the method of preparing a planographic printing plate of the present disclosure, the surfactants described in paragraphs 0128 to 0131 of JP2013-134341A can be used.

In addition, from the viewpoint of stable solubility or turbidity in water, a surfactant preferably has a hydrophile-lipophile balance (HLB) value of 6 or greater and more preferably has a HLB value of 8 or greater.

As the surfactant used in the developer, an anionic surfactant or a nonionic surfactant is preferable, and an anionic surfactant containing sulfonic acid or sulfonate or a nonionic surfactant having an aromatic ring and an ethylene oxide chain is particularly preferable.

The surfactant can be used alone or in combination.

The content of the surfactant in the developer is preferably in a range of 0.01% by mass to 10% by mass, and more preferably in a range of 0.01% by mass to 5% by mass.

In a case where as a buffer, carbonate ions and hydrogencarbonate ions are included to maintain the pH of the developer at 8.5 to 13.5, it is possible to suppress variations in pH even in a case where the developer is used for a long period of time, and it is possible to suppress developability deterioration and a development scum occurrence due to the variation in pH. To make carbonate ions and hydrogencarbonate ions present in the developer, carbonate and hydrogencarbonate may be added to the developer, or by adjusting the pH after carbonate or hydrogencarbonate is added, carbonate ions and hydrogencarbonate ions may be generated. Although carbonate and hydrogencarbonate are not particularly limited, an alkali metal salt is preferable. Examples of the alkali metal include lithium, sodium, and potassium, and sodium is particularly preferable. These may be used alone or in combination of two or more types thereof.

The total amount of carbonate and hydrogencarbonate is preferably in a range of 0.3% by mass to 20% by mass, more preferably in a range of 0.5% by mass to 10% by mass, and particularly preferably in a range of 1% by mass to 5% by mass, with respect to the total mass of the developer. In a case where the total amount is 0.3% by mass or greater, developability and processing capability are not reduced, and in a case where the total amount is 20% by mass or less, a precipitate or a crystal is less likely to be produced and at the time of the waste liquid treatment of the developer, gelation during neutralization is less likely to occur, and thus, trouble does not occur in the waste liquid treatment.

After the development step, a continuous or discontinuous drying step is preferably performed. Drying is performed by hot air, infrared rays, or far infrared rays.

As an automatic treatment machine suitably used for the method of preparing the planographic printing plate according to the present disclosure, a device having a developing unit and a drying unit is used, and a planographic printing plate is obtained by performing development and gumming on the positive type planographic printing plate precursor in a developer tank and drying the positive type planographic printing plate precursor in the drying unit.

In addition, for the purpose of improving printing durability or the like, it is also possible to heat the printing plate after developing in very strong conditions. The heating temperature is preferably in a range of 200°C to 500°C. In a case where the temperature is low, sufficient image strengthening effects are not obtained, and in a case where the temperature is too high, there is a possibility that problems such as deterioration of the support or thermal decomposition of the image area occur.

The planographic printing plate obtained in this manner is mounted on an offset printing machine, and can be suitably used in printing a large number of sheets.

### Examples

Hereinafter, the present invention will be described in detail based on examples. The materials, the used amounts, the proportions, the treatment contents, and the treatment procedures described in the following examples can be appropriately changed within the range not departing from the scope of the embodiment of the present invention. Therefore, the range of the embodiment of the present invention is not limited to the following specific examples. Moreover, "part" and "%" in the present examples respectively represent "part(s) by mass" and "% by mass" unless otherwise specified.

Further, a "compound represented by Formula SAA-1" is simply referred to as a "compound SAA-1".

Hereinafter, compounds SAA-1 to SAA-32, compounds SAS-1 to SAS-11, compounds SAO-1 to SAO-6, compounds DA-1 to DA-41, compounds DS-1 to DS-10, compounds DO-1 to DO-12, compounds DE-1 to DE-9, and compounds PEP-1 to PEP-25 in examples each correspond to the compounds SAA-1 to SAA-32, the compounds SAS-1 to SAS-11, the compounds SAO-1 to SAO-6, the compounds DA-1 to DA-41, the compounds DS-1 to DS-10, the compounds DO-1 to DO-12, the compounds DE-1 to DE-9, and the compounds PEP-1 to PEP-25 in the specific examples described above.

### (Synthesis Example)

### <Synthesis of diamine compound (SAA-7) containing sulfonamide group>

139.82 g of chlorosulfonic acid was weighed in a three-neck flask provided with a condenser and a stirrer, 29.43 g of xanthone (manufactured by Tokyo Chemical Industry Co., Ltd.) was added thereto at room temperature, and the resulting solution was stirred at room temperature for 1 hour. The temperature of the reaction solution was raised to 80°C, and the reaction solution was stirred for 8 hours. This reaction solution was cooled to room temperature while being stirred, and crystallized in 2 L of ice-cold water, followed by stirring for 10 minutes. This was collected by filtration, and the collected product was dissolved in 3 L of ethyl acetate. This ethyl acetate solution was transferred to a separating funnel, washing with pure water and liquid-liquid separation was performed two times, and washing with saturated saline and liquid-liquid separation was performed. After the organic layer was transferred to an Erlenmeyer flask, 30 g of magnesium sulfate was added thereto, followed by stirring, the solid content was removed by filtration, the ethyl acetate was distilled off using an evaporator, and the resulting product was vacuum-dried at 40°C for 24 hours, whereby 28 g of a precursor S-7 (disulfonic chloride) which was a target substance was obtained. It was confirmed from the NMR spectrum that the obtained product was the precursor (S-7). The precursor S-7 was analyzed using ¹H-NMR. The result thereof is shown below.
¹H-NMR data (deuterated dimethyl sulfoxide, 400 MHz, internal standard: tetramethylsilane)
δ (ppm) = 7.62-7.65 (d, 2H), 8.02-8.05 (d, 2H), 8.40 (s, 2H)
32.44 g of 1,4-phenylenediamine (manufactured by Tokyo Chemical Industry Co., Ltd.) and 170 g of tetrahydrofuran were weighed in a three-neck flask provided with a condenser and a stirrer, and the resulting mixture was stirred while being cooled to 0°C to 5°C. After 19.66 g of the precursor (S-7) obtained in the above-described manner was dissolved in 170 g of tetrahydrofuran, the solution was transferred to a dropping funnel, added dropwise to the three-neck flask for 1 hour during stirring, and stirred for 1 hour. After the temperature of the reaction solution was returned to room temperature and the reaction solution was stirred for 2 hours, 205.0 g of a 1 N sodium hydroxide aqueous solution was added to the reaction solution and then 150 g of pure water was added thereto and dissolved therein. The reaction solution was transferred to a separating funnel and washed with 300 mL of ethyl acetate three times, and then the water layer was recovered. Next, an aqueous solution obtained by dissolving 11.10 g of ammonium chloride (manufactured by Kanto Chemical Co., Inc.) in 500 mL of pure water was stirred, the water layer was added dropwise using a dropping funnel, and crystals were filtered. The filtrate was washed with 500 mL of pure water, washed with 500 mL of hexane, and filtered, thereby obtaining crystals. The crystals were vacuum-dried at 60°C for 24 hours, whereby 20.1 g of a target substance (SAA-7) was obtained. It was confirmed from the NMR spectrum that the obtained product was the target substance.

The target substance (SAA-7) was analyzed using ¹H-NMR. The result thereof is shown below.
¹H-NMR data (deuterated DMSO, 400 MHz, internal standard: tetramethylsilane)
δ (ppm) = 4.63 (s, 4H), 6.36-6.38 (d, 4H), 6.67-6.69 (d, 4H), 7.81-7.83 (d, 2H), 7.99-8.01 (d, 2H), 8.43 (s, 2H), 9.66 (s, 2H)

In the same manner as described above, SAA-1 to SAA-6 and SAA-8 to SAA-32 can be synthesized.

### <Synthesis of dithiol compound (SAS-8) containing sulfonamide group>

25.04 g of 4-aminobenzenethiol (manufactured by Tokyo Chemical Industry Co., Ltd.) and 170 g of tetrahydrofuran were weighed in a three-neck flask provided with a condenser and a stirrer, and the resulting mixture was stirred while being cooled to 0°C to 5°C. After 19.66 g of the precursor (S-7) obtained in the above-described manner was dissolved in 170 g of tetrahydrofuran, the solution was transferred to a dropping funnel, added dropwise to the three-neck flask for 1 hour during stirring, and stirred for 1 hour. After the temperature of the reaction solution was returned to room temperature and the reaction solution was stirred for 2 hours, 205.0 g of a 1 N sodium hydroxide aqueous solution was added to the reaction solution and then 150 g of pure water was added thereto and dissolved therein. The reaction solution was transferred to a separating funnel and washed with 300 mL of ethyl acetate three times, and then the water layer was recovered. Next, an aqueous solution obtained by dissolving 11.10 g of ammonium chloride (manufactured by Kanto Chemical Co., Inc.) in 500 mL of pure water was stirred, the water layer was added dropwise using a dropping funnel, and crystals were filtered. The filtrate was washed with 500 mL of pure water, washed with 500 mL of hexane, and filtered, thereby obtaining crystals. The crystals were vacuum-dried at 60°C for 24 hours, whereby 25.7 g of a target substance (SAS-8) was obtained. It was confirmed from the NMR spectrum that the obtained product was the target substance.

The target substance (SAS-8) was analyzed using ¹H-NMR. The result thereof is shown below.
¹H-NMR data (deuterated DMSO, 400 MHz, internal standard: tetramethylsilane)
δ (ppm) = 3.40 (s, 2H), 4.50 (s, 2H), 6.47 (d, 4H), 7.14 (d, 4H), 7.52 (d, 2H), 7.90 (d, 2H), 8.19 (s, 2H)

In the same manner as described above, SAS-1 to SAS-7 and SAS-9 to SAS-11 can be synthesized.

### <Synthesis of diol compound (SAO-5) containing sulfonamide group>

18.32 g of 2-(2-aminoethoxy) ethanol (manufactured by Tokyo Chemical Industry Co., Ltd.) and 170 g of tetrahydrofuran were weighed in a three-neck flask provided with a condenser and a stirrer, and the resulting mixture was stirred while being cooled to 0°C to 5°C. 19.66 g of the precursor (S-7) obtained in the above-described manner was dissolved in 170 g of tetrahydrofuran, the solution was transferred to a dropping funnel, added dropwise to the three-neck flask for 1 hour during stirring, and stirred for 1 hour. After the temperature of the reaction solution was returned to room temperature and the reaction solution was stirred for 2 hours, the solution was crystallized in 2 L of a 1 mol/L hydrochloric acid aqueous solution, and the crystallized resultant was filtered, transferred to a beaker, stirred with 1 L of pure water, washed, and then filtered. Next, the crystals were transferred to a beaker, stirred with 500 mL of acetonitrile and washed, thereby obtaining crystals. The crystals were vacuum-dried at 40°C for 24 hours, whereby 22.6 g of a target substance (SAO-5) was obtained. It was confirmed from the NMR spectrum that the obtained product was the target substance. The result thereof is shown below.
¹H-NMR data (deuterated dimethyl sulfoxide (deuterated DMSO), 400 MHz, internal standard: tetramethylsilane)
δ (ppm) = 2.98 (m, 4H), 3.31 (m, 4H), 3.39 (m, 4H), 3.40 (m, 4H), 4.49 (brs, 2H), 7.93 (d, 2H), 7.95 (brs, 2H), 8.25 (dd, 2H), 8.58 (d, 2H)

In the same manner as described above, SAO-1 to SAO-4 and SAO-6 can be synthesized.

### <Synthesis of specific polymer compound (PEP-9)>

158 g of EPIOL E-400 (manufactured by NOF Corporation, epoxy equivalent: 263), 750 g of γ-butyrolactone, 161 g of SAA-7 synthesized in the above-described manner, 6.0 g of tetrabutylammonium acetate (manufactured by Tokyo Chemical Industry Co., Ltd.) were added to a three-neck flask provided with a condenser and a stirrer, stirred at 80°C for 2 hours, and further stirred at 100°C for 3 hours. The resultant was cooled to 60°C, 29 g of methanol was added thereto, and the resulting solution was stirred at 60°C for 3 hours.

The reaction solution was poured into 2 L of pure water to precipitate a polymer. The resultant was collected by filtration, washed, and dried, whereby 290.9 g of a specific polymer compound (PEP-9) having a weight-average molecular weight of 49,000 was obtained.

It was confirmed from the NMR spectrum, the IR (infrared spectroscopy) spectrum, and GPC (in terms of polystyrene) that the obtained product was the target substance.

In the same manner as described above, compounds PEP-1 PEP-8 and compounds PEP-10 to PE-25 can be synthesized.

### (Examples 1 to 20 and Comparative Examples 1 and 5)

### <Preparation of support>

An aluminum alloy plate having a thickness of 0.3 mm of a material IS was subjected to the following (A-a) to (A-k) treatments, thereby producing a support for a planographic printing plate. Moreover, during all treatment steps, a washing treatment with water was performed, and after the washing treatment with water, liquid cutting was performed using a nip roller.

### (A-a) Mechanical roughening treatment (brush grain method)

While supplying a suspension of pumice (specific gravity of 1.1 g/cm³) to the surface of an aluminum plate as a polishing slurry liquid, a mechanical roughening treatment was performed using rotating bundle bristle brushes.

The median diameter (µm) of a polishing material was 30 µm, the number of the brushes was four, and the rotation speed (rpm) of the brushes was set to 250 rpm. The material of the bundle bristle brushes was nylon 6.10, the diameter of the brush bristles was 0.3 mm, and the bristle length was 50 mm. The brushes were produced by implanting bristles densely into the holes in a stainless steel cylinder having φ300 mm. The distance between two support rollers (φ200 mm) of the lower portion of the bundle bristle brush was 300 mm. The bundle bristle brushes were pressed until the load of a driving motor for rotating the brushes became 10 kW plus with respect to the load before the bundle bristle brushes were pressed against the aluminum plate. The rotation direction of the brushes was the same as the moving direction of the aluminum plate.

### (A-b) Alkali etching treatment

The aluminum plate obtained above was subjected to an etching treatment by spraying a caustic soda aqueous solution in which the concentration of caustic soda was 26% by mass and the concentration of aluminum ions was 6.5% by mass using a spray tube at a temperature of 70°C. Thereafter, washing with water by spraying was performed. The amount of aluminum dissolved was 10 g/m².

### (A-c) Desmutting treatment in acidic aqueous solution

Next, a desmutting treatment was performed in a nitric acid aqueous solution. As the nitric acid aqueous solution used in the desmutting treatment, the waste liquid of nitric acid used in electrochemical roughening of the next step was used. The liquid temperature was 35°C. The desmutting treatment was performed for 3 seconds by spraying the desmutting liquid using a spray.

### (A-d) Electrochemical roughening treatment

An electrochemical roughening treatment was continuously performed using an AC voltage of nitric acid electrolysis 60 Hz. As the electrolyte at this time, an electrolyte which had been adjusted to have a concentration of aluminum ions of 4.5 g/L by adding aluminum nitrate to a nitric acid aqueous solution having a concentration of 10.4 g/L at a temperature of 35°C was used. Using a trapezoidal rectangular waveform AC having a time tp until the current value reached a peak from zero of 0.8 msec and the duty ratio of 1:1 as the AC power source waveform, the electrochemical roughening treatment was performed using a carbon electrode as a counter electrode. As an auxiliary anode, ferrite was used. The current density was 30 A/dm² as the peak current value, and 5% of the current from the power source was separately flowed to the auxiliary anode. The electric quantity (C/dm²) was 185 C/dm² as the sum total of electric quantity at the time of anodization of the aluminum plate. Thereafter, washing with water by spraying was performed.

### (A-e) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.5 g/m².

### (A-f) Desmutting treatment in acidic aqueous solution

Next, a desmutting treatment was performed in a sulfuric acid aqueous solution. As the sulfuric acid aqueous solution used in the desmutting treatment, a solution in which the concentration of sulfuric acid was 170 g/L and the concentration of aluminum ions was 5 g/L was used. The liquid temperature was 30°C. The desmutting treatment was performed for 3 seconds by spraying the desmutting liquid using a spray.

### (A-g) Electrochemical roughening treatment

An electrochemical roughening treatment was continuously performed using an AC voltage of hydrochloric acid electrolysis 60 Hz. As the electrolyte, an electrolyte which had been adjusted to have a concentration of aluminum ions of 4.5 g/L by adding aluminum chloride to a hydrochloric acid aqueous solution having a concentration of 6.2 g/L at a liquid temperature of 35°C was used. Using a trapezoidal rectangular waveform AC having a time tp until the current value reached a peak from zero of 0.8 msec and the duty ratio of 1:1, the electrochemical roughening treatment was performed using a carbon electrode as a counter electrode. As an auxiliary anode, ferrite was used.

The current density was 25 A/dm² as the peak current value, and the electric quantity (C/dm²) in the hydrochloric acid electrolysis was 63 C/dm² as the sum total of electric quantity at the time of anodization of the aluminum plate. Thereafter, washing with water by spraying was performed.

### (A-h) Alkali etching treatment

The aluminum plate obtained above was subjected to an etching treatment by spraying a caustic soda aqueous solution in which the concentration of caustic soda was 5% by mass and the concentration of aluminum ions was 0.5% by mass using a spray tube at a temperature of 50°C. Thereafter, washing with water by spraying was performed. The amount of aluminum dissolved was 0.1 g/m².

### (A-i) Desmutting treatment in acidic aqueous solution

Next, a desmutting treatment was performed in a sulfuric acid aqueous solution. Specifically, the desmutting treatment was performed at a liquid temperature of 35°C for 4 seconds using the waste liquid (aluminum ions having a concentration of 5 g/L were dissolved in a sulfuric acid aqueous solution having a concentration of 170 g/L) generated in the anodization treatment step. The desmutting treatment was performed for 3 seconds by spraying the desmutting liquid using a spray.

### (A-j) Anodization treatment

An anodization treatment was performed using an anodization apparatus (the length of each of a first electrolytic portion and a second electrolytic portion was 6 m, the length of each of a first feeding portion and a second feeding portion was 3 m, and the length of each of a first feeding electrode and a second feeding electrode was 2.4 m) of a two-stage feeding electrolytic treatment method. As the electrolyte supplied to the first electrolytic portion and the second electrolytic portion, sulfuric acid was used. All electrolytes have a concentration of sulfuric acid of 50 g/L (including 0.5% by mass of aluminum ions) and were at a temperature of 20°C. Thereafter, washing with water by spraying was performed.

### (A-k) Silicate treatment

To ensure hydrophilicity of the non-image area, a silicate treatment was performed by dipping at 50°C for 7 seconds using 2.5% by mass No. 3 sodium silicate aqueous solution. The amount of Si attached was 10 mg/m². Thereafter, washing with water by spraying was performed.

### <Formation of undercoat layer>

The support prepared in the above-described manner was coated with an undercoat layer coating solution 1 prepared by mixing the components with the composition shown below, and the coating solution was dried at 80°C for 15 seconds, thereby preparing a support provided with an undercoat layer. The coating amount after drying was 15 mg/m².

### (Undercoat layer coating solution 1)

- Following copolymer (Et represents an ethyl group) having a weight-average molecular weight of 28,000: 0.3 parts
- Methanol: 100 parts
- Water: 1 part

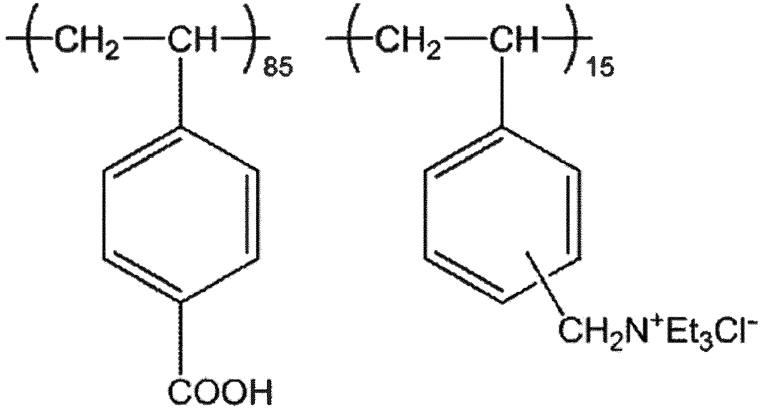

### <Formation of image recording layer>

After the obtained support was coated with a coating solution composition (I) for forming a lower layer having the following composition using a wire bar, and the resulting product was dried in a drying oven at 150°C for 40 seconds so that a lower layer was provided. The coating amount became 1.0 g/m². After the lower layer was provided, the lower layer was coated with a coating solution composition (II) for forming an upper layer having the following composition using a wire bar, whereby an upper layer was provided. After the coating, the resulting product was dried at 150°C for 40 seconds, whereby a positive type planographic printing plate precursor in which the coating amount of the lower layer and the upper layer was 1.2 g/m² was obtained.

### (Coating solution composition (I) for forming lower layer)

- Specific polymer compound listed in Table 2: 3.5 parts
- m,p-Cresol novolac (m/p ratio = 6/4, weight-average molecular weight of 6,000): 0.6 parts
- Infrared absorbent (IR coloring agent (1): following structure): 0.2 parts
- 4,4'-Bishydroxyphenyl sulfone: 0.3 parts
- Tetrahydrophthalic acid: 0.4 parts
- p-Toluenesulfonic acid: 0.02 parts
- 3-Methoxy-4-diazodiphenylamine hexafluorophosphate: 0.06 parts
- Product obtained by replacing a counter ion of ethyl violet with 6-hydroxynaphthalenesulfonic acid: 0.15 parts
- Fluorine-based surfactant (MEGAFACE F-780, manufactured by DIC Corporation): 0.07 parts
- Methyl ethyl ketone: 30 parts
- 1-Methoxy-2-butyrolactone: 15 parts
- γ-Butyrolactone: 15 parts

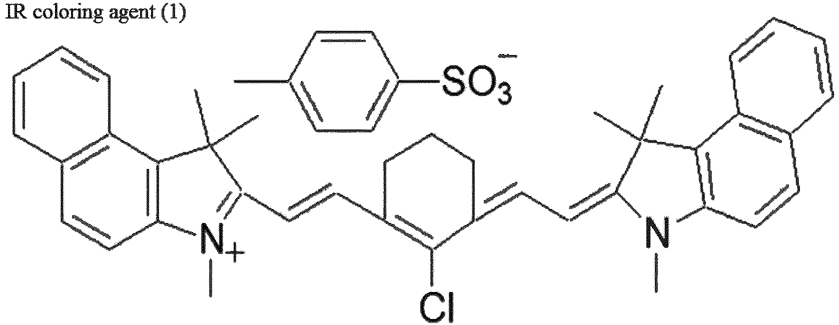

### (Coating solution composition (II) for forming upper layer)

- Novolac resin (m-cresol/p-cresol/phenol = 3/2/5, weight-average molecular weight (Mw): 8,000): 0.68 parts
- Infrared absorbent (IR coloring agent (1): above structure): 0.045 parts
- Fluorine-based surfactant (MEGAFACE F-780, manufactured by DIC Corporation): 0.03 parts
- Methyl ethyl ketone: 15.0 parts
- 1-Methoxy-2-propanol: 30.0 parts
- 5-Benzoyl-4-hydroxy-2-methoxybenzenesulfonate of 1-(4-methylbenzyl)-1-phenylpiperidinium: 0.01 parts

The following evaluations were performed on the obtained positive type planographic printing plate precursors, and the results are shown in the following Table 2.

### <Evaluation of developability>

Drawing of a test pattern was performed on each positive type planographic printing plate precursor of each example and each comparative example using a Trendsetter VX (manufactured by Creo Company) by changing the exposure energy. Thereafter, the resulting product was immersed in a developing bath charged with a developer XP-D (which was made to have a conductivity of 43 mS/cm by diluting) (manufactured by Fujifilm Corporation), and the time taken until the dissolution of the image area was started at a development temperature of 30°C and the time required for developing the non-image area were measured. The time taken until the dissolution of the image area was started (also referred to as the "image area dissolution starting time") was set as the time taken until the measured value of the optical density (OD value) in the image area was decreased by 0.05 from the measured value of the optical density in the image area before the development treatment. Further, the immersion time at which a difference between the measured value of the optical density in the non-image area and the measured value of the optical density of the Al support reached 0.02 or less was set as the non-image area development time. In both cases, the optical density was measured using a spectrophotometer SpectroEye (manufactured by GretagMacbeth Company). As the time until the dissolution of the image area is started is longer, the resistance to an alkali aqueous solution is excellent. Further, as the non-image area development time is shorter, the solubility of the non-image area in an alkali aqueous solution is excellent and an alkali aqueous solution developability (highlight reproducibility) is good. Accordingly, it is evaluated that the positive type planographic printing plate precursor has excellent developability in a case where the image area dissolution starting time is long, the non-image area development time is short, and the difference between the image area dissolution starting time and the non-image area development time is large. The results are shown in Table 2.

### <Evaluation of printing durability>

Drawing of a test pattern was performed on each positive type planographic printing plate precursor of each example and each comparative example using a Trendsetter (manufactured by Creo company) at a beam intensity of 9 W and a drum rotation speed of 150 rpm. Thereafter, using PS PROCESSOR LP940H (manufactured by Fujifilm Corporation) charged with a developer XP-D (which was made to have a conductivity of 43 mS/cm by diluting) (manufactured by Fujifilm Corporation), development was performed at a developing temperature of 30°C and the development time was set to the same as the non-image area development time listed in Table 2. This was continuously printed using a printer LITHRONE (manufactured by KOMORI Corporation). As the ink, a tokunen black ink (manufactured by TOYO INK CO., LTD.) containing calcium carbonate was used as a model of a low-grade material. At this time, by visually observing how many sheets could be printed while maintaining a sufficient ink density, the printing durability was evaluated. It was evaluated that the printing durability was excellent as the number of sheets was larger. The results are shown in Table 2.

### <Evaluation of chemical resistance>

Exposure, development, and printing were performed on each positive type planographic printing plate precursor of each example and each comparative example in the same manner as in the evaluation of the printing durability. In this time, every time 5,000 sheets were printed, a step of wiping the plate surface with a cleaner (manufactured by Fujifilm Corporation, multi cleaner) was performed, and the chemical resistance was evaluated. The printing durability at this time was evaluated as 1 in a case where the number of printed sheets was 95% to 100% of the number of printing endurable sheets described above, evaluated as 2 in a case where the number of printed sheets was 80% or greater and less than 95%, evaluated as 3 in a case where the number of printed sheets was 60% or greater and less than 80%, and evaluated as 4 in a case where the number of printed sheets was less than 60%. Even in a case where the step of wiping the plate surface with a cleaner was performed, as the change in the printing durability index was smaller, the chemical resistance was evaluated to be excellent. The results are shown in the following Table 2.

### <Evaluation of ink impression properties>

Each positive type planographic printing plate precursor of each example and each comparative example was mounted on a plate material supply device and exposed fully automatically and continuously, and the developer was used for a development treatment and discharged to a stocker. The resolution at the time of exposure was set to 2,400 dpi (dots per inch, the number of dots per inch: 2.54 cm) and 175 lines, and the exposure was performed by changing the halftone dots in a range of 0.5% to 99.5%. Printing was performed on the obtained planographic printing plate using an R201 type printer (manufactured by Manroland sheetfed) and DAICURE ABILIO (manufactured by DIC Graphics Corporation) as an ink, visual confirmation that a region where the ink was not attached to a printing unit was not present was made, and the number of printed sheets required so far was set as an index of the ink impression properties. It was evaluated that the ink impression properties were excellent as the number of printed sheets required for ink impression was smaller. The evaluation results are listed in Table 2.

**[Table 2]**

| | Specific polymer compound | Evaluation results | | | | |
|---|---|---|---|---|---|---|
| | | Non-image area development time (sec) | Image area dissolution starting time (sec) | Printing durability number of printed sheets (10,000 sheets) | Chemical resistance | Ink impression properties (sheets) |
| Example 1 | PEP-1 | 9 | 27 | 11 | 1 | 9 |
| Example 2 | PEP-2 | 10 | 26 | 11 | 1 | 9 |
| Example 3 | PEP-3 | 9 | 29 | 10 | 1 | 8 |
| Example 4 | PEP-4 | 10 | 31 | 10 | 2 | 8 |
| Example 5 | PEP-5 | 9 | 27 | 13 | 1 | 10 |
| Example 6 | PEP-6 | 10 | 27 | 14 | 2 | 11 |
| Example 7 | PEP-7 | 9 | 27 | 13 | 1 | 11 |
| Example 8 | PEP-8 | 8 | 32 | 13 | 1 | 8 |
| Example 9 | PEP-9 | 8 | 34 | 10 | 2 | 8 |
| Example 10 | PEP-10 | 8 | 34 | 10 | 2 | 8 |
| Example 11 | PEP-12 | 12 | 32 | 13 | 1 | 10 |
| Example 12 | PEP-14 | 12 | 33 | 12 | 2 | 10 |
| Example 13 | PEP-15 | 8 | 28 | 9 | 1 | 9 |
| Example 14 | PEP-17 | 8 | 30 | 9 | 2 | 8 |
| Example 15 | PEP-19 | 8 | 32 | 12 | 2 | 8 |
| Example 16 | PEP-20 | 10 | 27 | 12 | 1 | 9 |
| Example 17 | PEP-21 | 10 | 26 | 11 | 1 | 9 |
| Example 18 | PEP-22 | 7 | 26 | 10 | 2 | 11 |
| Example 19 | PEP-23 | 9 | 27 | 12 | 1 | 9 |
| Example 20 | PEP-25 | 8 | 32 | 11 | 1 | 8 |
| Comparative Example 1 | R-1 | 150 | 200 | 9 | 4 | 20 |
| Comparative Example 2 | R-2 | 12 | 20 | 6 | 4 | 22 |
| Comparative Example 3 | R-3 | 15 | 22 | 5 | 3 | 21 |
| Comparative Example 4 | R-4 | 14 | 23 | 3 | 4 | 25 |
| Comparative Example 5 | R-5 | 14 | 25 | 3 | 4 | 25 |

As shown in the results listed in Table 2, it was understood that the developability, the printing durability, the chemical resistance, and the ink impression properties are improved in a case where the positive type photosensitive resin composition of the present disclosure is used.

### <Synthesis Example of specific polymer compound R-1 used in Comparative Example 1>

350 g of JER1007 (manufactured by Mitsubishi Chemical Corporation, epoxy equivalent: 1,750), 689 g of γ-butyrolactone, 22 g of diethylene glycol bis(3-aminopropyl) ether (manufactured by Tokyo Chemical Industry Co., Ltd.), and 6.0 g of tetrabutylammonium acetate (manufactured by Tokyo Chemical Industry Co., Ltd.) were added to a three-neck flask provided with a condenser and a stirrer, stirred at 80°C for 2 hours, and further stirred at 100°C for 3 hours. The resultant was cooled to 60°C, 10 g of methanol was added thereto, and the resulting solution was stirred at 60°C for 3 hours.

The reaction solution was poured into 2 L of pure water to precipitate a polymer. The resultant was collected by filtration, washed, and dried, whereby 360.1 g of a specific polymer compound (R-1) having a weight-average molecular weight of 55,000 was obtained.

It was confirmed from the NMR spectrum, the IR (infrared spectroscopy) spectrum, and the GPC (in terms of polystyrene) that the obtained product was the target substance.

Hereinafter, compounds R-3 to R-5 were synthesized in the same manner as that for the compound R-1.

### < Synthesis Example of specific polymer compound R-2 used in Comparative Example 2>

6.97 g of 1,6-hexanediamine (manufactured by Tokyo Chemical Industry Co., Ltd.) and 53.9 g of N-methylpyrrolidone (manufactured by Kanto Chemical Co., Inc.) were weighed in a three-neck flask provided with a condenser and a stirrer, and the resulting mixture was stirred at room temperature while flowing nitrogen to obtain a uniform solution. Next, 9.49 g of pyridine (manufactured by Kanto Chemical Co., Inc.) and 7.33 g of 4-dimethylaminopyridine (manufactured by Tokyo Chemical Industry Co., Ltd.) were weighed and added to the reaction solution so as to be dissolved therein. Next, 22.03 g of 4,4'-oxybis(benzenesulfonyl chloride) (manufactured by Tokyo Chemical Industry Co., Ltd.) was added to the flask and stirred at room temperature for 1 hour, and the solution was heated to 60°C and allowed to react for 10 hours. The reaction solution was added dropwise to a mixed solution of 0.5 L of pure water and 0.5 L of methanol to precipitate a polymer. The resultant was collected by filtration, washed, and dried, whereby 25.5 g of a polymer compound R-2 having a weight-average molecular weight of 52,000 was obtained. It was confirmed from the NMR spectrum, the IR (infrared spectroscopy) spectrum, and GPC (in terms of polystyrene) that the obtained product was the target substance.

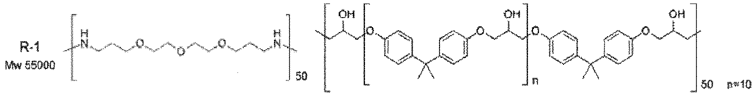

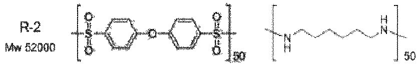

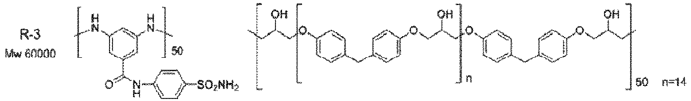

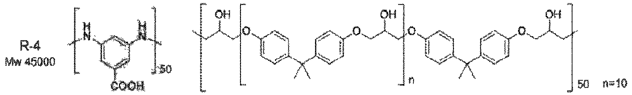

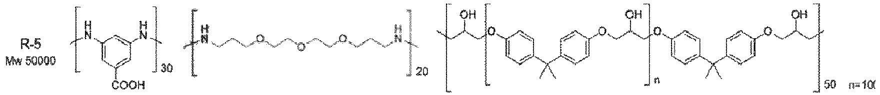

### (Examples 21 to 40 and Comparative Examples 6 to 10)

### <Preparation of support>

In the same manner as in Example 1, each support for a planographic printing plate was prepared.

### <Formation of undercoat layer>

In the same manner as in Example 1, each support having an undercoat layer was prepared.

### <Formation of image recording layer>

After a coating solution composition (III) for forming a lower layer having the following composition was applied to the obtained support A using a wire bar, the resulting product was dried in a drying oven at 150°C for 40 seconds such that the coating amount became 1.0 g/m², whereby a lower layer was provided. After the lower layer was provided, a coating solution composition (IV) for forming an upper layer having the following composition was applied using a wire bar, whereby an upper layer was provided. After application, the resulting product was dried at 150°C for 40 seconds, whereby a positive type planographic printing plate precursor in which the coating amount of the lower layer and the upper layer was 1.2 g/m² was obtained.

### (Coating solution composition (III) for forming lower layer)

Copolymer (weight-average molecular weight of 65,000) of N-(p-aminosulfonylphenyl)methacrylamide/methyl methacrylate/acrylonitrile = 35/35/30 (molar ratio): 3.5 parts
- m,p-Cresol novolac (m/p ratio = 6/4, weight-average molecular weight of 6,000): 0.6 parts
- Infrared absorbent (above IR coloring agent (1)): 0.2 parts
- 4,4'-Bishydroxyphenyl sulfone: 0.3 parts
- Tetrahydrophthalic acid: 0.4 parts
- p-Toluenesulfonic acid: 0.02 parts
- 3-Methoxy-4-diazodiphenylamine hexafluorophosphate: 0.06 parts
- Product obtained by replacing a counter ion of ethyl violet with 6-hydroxynaphthalenesulfonic acid: 0.15 parts
- Fluorine-based surfactant (MEGAFACE F-780, manufactured by DIC Corporation): 0.07 parts
- Methyl ethyl ketone: 30 parts
- 1-Methoxy-2-butyrolactone: 15 parts
- γ-butyrolactone: 15 parts

### (Coating solution composition (IV) for forming upper layer)

- Specific polymer compound described in Table 3: 0.3 parts
- Novolac resin (m-cresol/p-cresol/phenol = 3/2/5, Mw 8,000): 0.4 parts
- Infrared absorbent (above IR coloring agent (1)): 0.045 parts
- Fluorine-based surfactant (MEGAFACE F-780, manufactured by DIC Corporation): 0.03 parts
- Methyl ethyl ketone: 15.0 parts
- 1-Methoxy-2-propanol: 30.0 parts
- 5-Benzoyl-4-hydroxy-2-methoxybenzenesulfonate of 1-(4-methylbenzyl)-1-phenylpiperidinium: 0.01 parts

The dissolution starting time of the image area, the non-image area development time, the printing durability, the chemical resistance, and the ink impression properties of the positive type planographic printing plate precursors obtained in each example and each comparative example were evaluated in the same manner as in Example 1. The results are listed in Table 3.

**[Table 3]**

| | Specific polymer compound | Evaluation results | | | | |
|---|---|---|---|---|---|---|
| | | Non-image area development time (sec) | Image area dissolution starting time (sec) | Printing durability number of printed sheets (10,000 sheets) | Chemical resistance | Ink impression properties (sheets) |
| Example 21 | PEP-1 | 8 | 26 | 10 | 1 | 8 |
| Example 22 | PEP-2 | 9 | 25 | 10 | 1 | 8 |
| Example 23 | PEP-3 | 9 | 28 | 10 | 1 | 7 |
| Example 24 | PEP-4 | 9 | 29 | 10 | 2 | 7 |
| Example 25 | PEP-5 | 9 | 26 | 13 | 1 | 9 |
| Example 26 | PEP-6 | 10 | 26 | 14 | 1 | 10 |
| Example 27 | PEP-7 | 9 | 26 | 13 | 1 | 10 |
| Example 28 | PEP-8 | 8 | 31 | 13 | 1 | 7 |
| Example 29 | PEP-9 | 8 | 33 | 10 | 2 | 7 |
| Example 30 | PEP-10 | 8 | 32 | 10 | 2 | 7 |
| Example 31 | PEP-12 | 11 | 31 | 13 | 1 | 9 |
| Example 32 | PEP-14 | 11 | 32 | 12 | 2 | 8 |
| Example 33 | PEP-15 | 8 | 27 | 9 | 1 | 8 |
| Example 34 | PEP-17 | 8 | 28 | 9 | 2 | 7 |
| Example 35 | PEP-19 | 8 | 30 | 12 | 2 | 7 |
| Example 36 | PEP-20 | 9 | 25 | 12 | 1 | 8 |
| Example 37 | PEP-21 | 9 | 24 | 11 | 1 | 8 |
| Example 38 | PEP-22 | 7 | 24 | 10 | 2 | 10 |
| Example 39 | PEP-23 | 8 | 26 | 12 | 1 | 8 |
| Example 40 | PEP-25 | 8 | 30 | 11 | 1 | 7 |
| Comparative Example 6 | R-1 | 140 | 180 | 8 | 4 | 18 |
| Comparative Example 7 | R-2 | 12 | 20 | 5 | 4 | 21 |
| Comparative Example 8 | R-3 | 13 | 20 | 5 | 3 | 20 |
| Comparative Example 9 | R-4 | 12 | 22 | 3 | 4 | 23 |
| Comparative Example 10 | R-5 | 12 | 22 | 3 | 4 | 23 |

As shown in the results listed in Table 3, it was understood that the developability, the printing durability, the chemical resistance, and the ink impression properties are improved in a case where the positive type photosensitive resin composition of the present disclosure is used.

### (Examples 41 to 60 and Comparative Examples 11 to 15)

### <Preparation of support>

In the same manner as in Example 1, each support for a planographic printing plate was prepared.

### <Formation of undercoat layer>

In the same manner as in Example 1, each support having an undercoat layer was prepared.

### <Formation of image recording layer>

After each of the obtained supports A was coated with a coating solution composition (V) for forming an image recording layer having the following composition using a wire bar, the resulting product was dried in a drying oven at 140°C for 50 seconds, thereby obtaining a positive type planographic printing plate precursor having a coating amount of 1.2 g/m².

### [Coating solution composition (V) for forming image recording layer]

- m,p-Cresol novolac (m/p ratio = 6/4, weight-average molecular weight of 6,000): 0.474 parts
- Specific polymer compound listed in Table 4: 2.37 parts
- Infrared absorbent (above IR coloring agent (1)): 0.155 parts
- 2-Methoxy-4-(N-phenylamino)benzenediazonium hexafluorophosphate: 0.03 parts
- Tetrahydrophthalic anhydride: 0.19 parts
- Product obtained by replacing a counter ion of ethyl violet with 6-hydroxy-β-naphthalenesulfonic acid: 0.11 parts
- Fluorine-based surfactant (MEGAFACE F-780, manufactured by Dainippon Ink and Chemicals): 0.07 parts
- p-Toluenesulfonic acid: 0.008 parts
- Bis-p-hydroxyphenyl sulfone: 0.13 parts
- 3,3'-Dimyristyl thiodipropionate : 0.04 parts
- Lauryl stearate: 0.02 parts
- N,N-dimethylacetamide: 13 parts
- Methyl ethyl ketone: 24 parts
- 1-Methoxy-2-propanol: 11 parts
- γ-Butyrolactone: 15 parts

The dissolution starting time of the image area, the non-image area development time, the printing durability, the chemical resistance, and the ink impression properties of the positive type planographic printing plate precursors obtained in each example and each comparative example were evaluated in the same manner as in Example 1. The results are listed in Table 4.

**[Table 4]**

| | Specific polymer compound | Evaluation results | | | | |
|---|---|---|---|---|---|---|
| | | Non-image area development time (sec) | Image area dissolution starting time (sec) | Printing durability number of printed sheets (10,000 sheets) | Chemical resistance | Ink impression properties (sheets) |
| Example 41 | PEP-1 | 8 | 25 | 10 | 1 | 8 |
| Example 42 | PEP-2 | 9 | 24 | 10 | 1 | 8 |
| Example 43 | PEP-3 | 8 | 27 | 9 | 1 | 7 |
| Example 44 | PEP-4 | 9 | 28 | 9 | 2 | 7 |
| Example 45 | PEP-5 | 8 | 25 | 12 | 1 | 9 |
| Example 46 | PEP-6 | 9 | 25 | 12 | 2 | 10 |
| Example 47 | PEP-7 | 8 | 25 | 12 | 1 | 10 |
| Example 48 | PEP-8 | 7 | 30 | 12 | 1 | 6 |
| Example 49 | PEP-9 | 8 | 31 | 9 | 1 | 7 |
| Example 50 | PEP-10 | 8 | 31 | 9 | 2 | 7 |
| Example 51 | PEP-12 | 11 | 30 | 12 | 1 | 9 |
| Example 52 | PEP-14 | 11 | 30 | 11 | 2 | 8 |
| Example 53 | PEP-15 | 8 | 26 | 8 | 1 | 8 |
| Example 54 | PEP-17 | 8 | 28 | 8 | 2 | 7 |
| Example 55 | PEP-19 | 7 | 30 | 11 | 2 | 7 |
| Example 56 | PEP-20 | 9 | 25 | 11 | 1 | 8 |
| Example 57 | PEP-21 | 9 | 25 | 10 | 1 | 8 |
| Example 58 | PEP-22 | 7 | 24 | 9 | 1 | 10 |
| Example 59 | PEP-23 | 8 | 25 | 10 | 1 | 8 |
| Example 60 | PEP-25 | 8 | 30 | 10 | 1 | 7 |
| Comparative Example 11 | R-1 | 120 | 135 | 8 | 4 | 18 |
| Comparative Example 12 | R-2 | 10 | 18 | 5 | 4 | 21 |
| Comparative Example 13 | R-3 | 13 | 20 | 4 | 3 | 20 |
| Comparative Example 14 | R-4 | 12 | 20 | 3 | 4 | 23 |
| Comparative Example 15 | R-5 | 12 | 22 | 3 | 4 | 23 |

As shown in the results listed in Table 4, it was understood that the developability, the printing durability, the chemical resistance, and the ink impression properties are improved in a case where the positive type photosensitive resin composition of the present disclosure is used.

## Claims

1. A positive type photosensitive resin composition comprising:
a polymer compound which comprises, in a main chain thereof, a sulfonamide group and a structure represented by Formula A-1; and
an infrared absorbent, 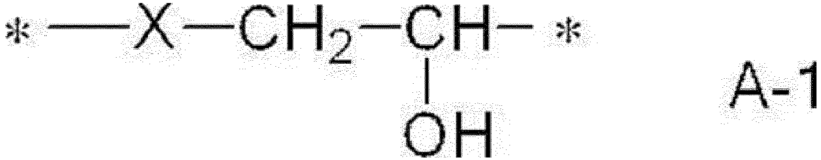 wherein, in Formula A-1, X represents -NR¹-, -S-, or -O-; R¹ represents a hydrogen atom or an alkyl group; and each symbol "*" independently represents a bonding position with respect to another structure.

2. The positive type photosensitive resin composition according to claim 1, wherein X represents -NR¹-.

3. The positive type photosensitive resin composition according to claim 1, wherein the polymer compound comprises a constitutional unit represented by Formula A-2 as a constitutional unit having the structure represented by Formula A-1: 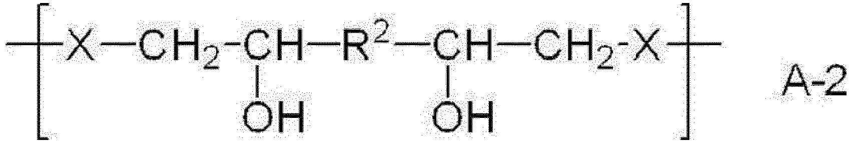 wherein, in Formula A-2, R² represents a divalent linking group; each X independently represents -NR¹-, -S-, or -O-, and each R¹ independently represents a hydrogen atom or an alkyl group.

4. The positive type photosensitive resin composition according to claim 3, wherein R² represents a divalent linking group comprising a bisphenol structure, a divalent linking group comprising an alkyleneoxy group, or a divalent linking group comprising a biphenyl structure.

5. The positive type photosensitive resin composition according to claim 3 or 4, wherein both of two X's in Formula A-2 represent -NR¹-.

6. The positive type photosensitive resin composition according to any one of claims 1 to 5, wherein the polymer compound comprises a constitutional unit represented by Formula B-1 as a constitutional unit containing the sulfonamide group: 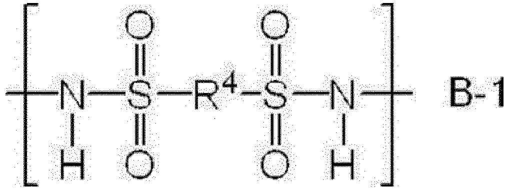 wherein, in Formula B-1, R⁴ represents a divalent linking group.

7. The positive type photosensitive resin composition according to claim 6, wherein R⁴ represents a divalent linking group comprising a polycyclic structure or a divalent linking group comprising a phenylene group.

8. The positive type photosensitive resin composition according to claim 6 or 7, wherein the constitutional unit represented by Formula B-1 comprises at least one constitutional unit selected from the group consisting of constitutional units each represented by any one of Formulae B1-1 to B1-6: 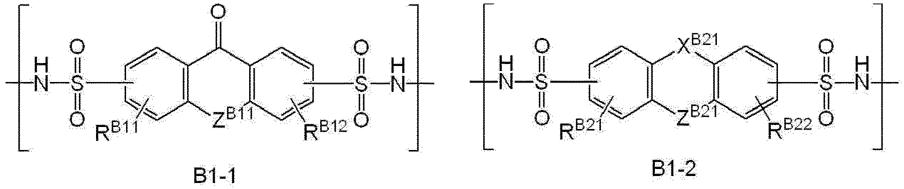 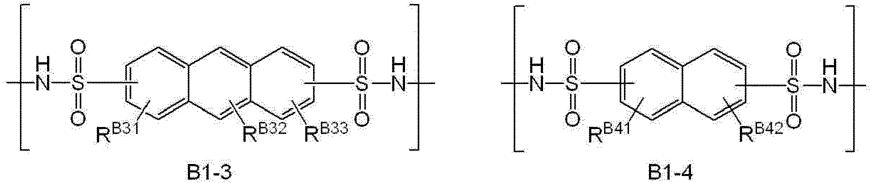 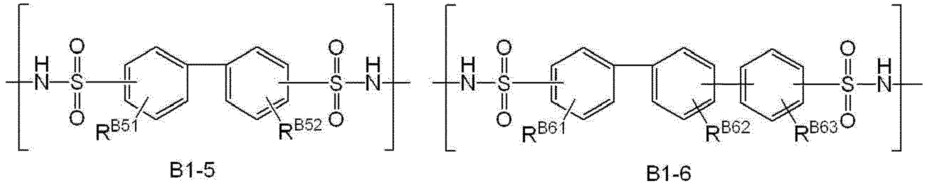 wherein, in Formulae B1-1 to B1-6, each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom; Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group; X^{B21} represents -C(R')₂-, -O-, -NR'-, -S-, or a single bond, and each R independently represents a hydrogen atom or an alkyl group.

9. The positive type photosensitive resin composition according to any one of claims 1 to 5, wherein the polymer compound comprises a constitutional unit represented by Formula B-2 as a constitutional unit comprising the sulfonamide group: 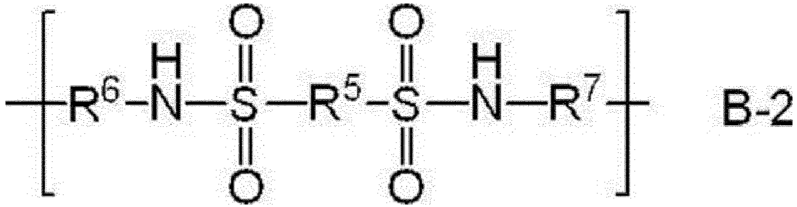 wherein, in Formula B-2, each of R⁵ to R⁷ independently represents a divalent linking group.

10. The positive type photosensitive resin composition according to claim 9, wherein R⁵ represents a divalent linking group comprising a phenylene group or a divalent linking group comprising a polycyclic structure, and each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups linked to one another.

11. The positive type photosensitive resin composition according to claim 9, wherein the constitutional unit represented by Formula B-2 comprises at least one constitutional unit selected from the group consisting of constitutional units each represented by any one of Formulae B2-1 to B2-6: 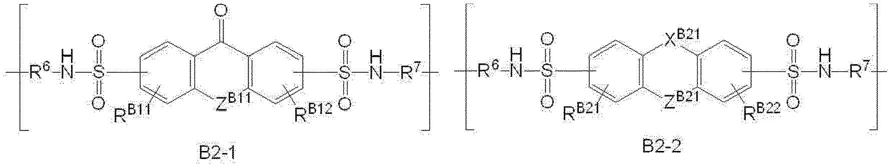 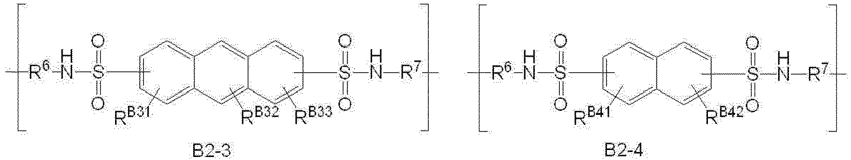 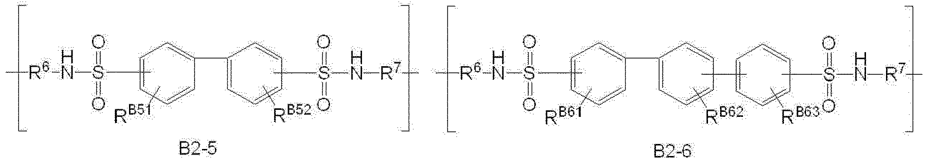 wherein, in Formulae B2-1 to B2-6, each of R⁶ and R⁷ independently represents an alkylene group, an arylene group, a divalent saturated alicyclic hydrocarbon group, a divalent unsaturated alicyclic hydrocarbon group, or a divalent group formed by a plurality of these groups linked to one another; each of R^{B11}, R^{B12}, R^{B21}, R^{B22}, R^{B31} to R^{B33}, R^{B41}, R^{B42}, R^{B51}, R^{B52}, and R^{B61} to R^{B63} independently represents a hydrogen atom, a sulfonamide group, a hydroxyl group, a carboxyl group, an alkyl group, or a halogen atom; Z^{B11} represents -C(R)₂-, -C(=O)-, -O-, -NR-, -S-, or a single bond, Z^{B21} represents -C(R)₂-, -O-, -NR-, -S-, or a single bond, each R independently represents a hydrogen atom or an alkyl group; X^{B21} represents -C(R')₂-, -O-, -NR'-, -S-, or a single bond, and each R independently represents a hydrogen atom or an alkyl group.

12. A positive type planographic printing plate precursor comprising:
a support which has a hydrophilic surface; and
an image recording layer which comprises the positive type photosensitive resin composition according to any one of claims 1 to 11, on the support.

13. The positive type planographic printing plate precursor according to claim 12, wherein the image recording layer comprises a lower layer and an upper layer from a support side, and at least one of the lower layer and the upper layer comprises the positive type photosensitive resin composition.

14. The positive type planographic printing plate precursor according to claim 12 or 13, further comprising an undercoat layer between the support having the hydrophilic surface and the image recording layer.

15. A method of preparing a planographic printing plate, comprising:
an exposure step of subjecting the positive type planographic printing plate precursor according to any one of claims 12 to 14 to image-wise exposure; and
a development step of subjecting the exposed positive type planographic printing plate precursor to development using an alkali aqueous solution having a pH of 8.5 to 13.5.
